# EUROPÄISCHE PATENTSCHRIFT

(11) **EP 0 683 595 B1**
(45) Veröffentlichungstag und Bekanntmachung des Hinweises auf die Patenterteilung: **05.12.2001**
(21) Anmeldenummer: 95105829.6
(22) Anmeldetag: 19.04.1995
(51) Int. Cl.: H04N 1/04, H04N 1/193

(54) **Vorrichtung zur Erzeugung eines Bildes**
Image forming device
Dispositif de formation d'image

(30) Priorität: 20.04.1994 DE 4413829
(43) Veröffentlichungstag der Anmeldung: 22.11.1995
(73) Patentinhaber: Deutsches Zentrum für Luft- und Raumfahrt e.V., 53175 Bonn (DE)
(72) Erfinder: Opower, Hans, Prof. Dr., D-82152 Krailling (DE); Becker, Uwe, Dr. rer. nat, 70499 Stuttgart (DE); Brauch, Uwe, Dr. rer. nat, 70565 Stuttgart (DE)
(74) Vertreter: Hoeger, Stellrecht & Partner

(56) Entgegenhaltungen:
- EP-A- 0 458 270
- US-A- 5 294 944

## Beschreibung

Die Erfindung betrifft eine Vorrichtung zur Erzeugung eines, insbesondere für ein menschliches Auge sichtbaren Bildes in einer Bildfläche, umfassend eine Strahlungsquelle, welche über eine Projektionsoptik in dem Bild mindestens eine Bildreihe durch Ausleuchten einzelner nebeneinander liegender Bildflecken erzeugt.

Eine derartige Vorrichtung ist beispielsweise aus der Bilderzeugung mit Gaslasern bekannt, bei welcher ein Laserstrahl eines Gaslasers über die Projektionsoptik zur Erzeugung eines für das menschliche Auge als Ganzes erkennbaren Bildes aus einzelnen Bildpunkten bewegt wird. Derartige Vorrichtungen dienen beispielsweise dazu, nicht nur statische Bilder sondern auch bewegte Bilder, wie beispielsweise Fernsehbilder, in Großformat und gegebenenfalls auch mehrfarbig zu erzeugen.

Die Verwendung derartiger Gaslaser zur Bilderzeugung erfordert einen großen apparativen Aufwand zur Erzeugung des Laserstrahls und außerdem einen großen Aufwand bei der Projektionsoptik, um den Laserstrahl definiert abzulenken.

EP-A-0 458 270 zeigt ein Abbildungsgerät gemäß dem Stand der Technik mit Halbleiteremitter-Feld und einem Polygon als Ablenkspiegel. Das Bild wird mittels Lichtwandler verstärkt.

US-A-5,294,944 zeigt einen Farbbild-Drucker mit mehreren gleichen Lasern zur Erzeugung des Bildes.

Der Erfindung liegt daher die Aufgabe zugrunde, eine Vorrichtung der gattungsgemäßen Art derart zu verbessern, daß die Bilderzeugung möglichst einfach und daher auch kostengünstig möglich ist.

Diese Aufgabe wird bei einer Vorrichtung der eingangs beschriebenen Art erfindungsgemäß dadurch gelöst, daß zur Ausleuchtung der Bildflecken der Bildreihe eine eine Vielzahl von Halbleiteremittern umfassende Leuchtreihe vorgesehen ist, daß die Projektionsoptik mindestens einen Austrittsfleck für die Strahlung jedes Halbleiteremitters einem der Bildflecken zuordnet und daß die Projektionsoptik die Austrittsflecke aller Halbleiteremitter gleichzeitig auf die diesen zugeordneten Bildflecken abbildet.

Die erfindung wird durch die in Anspruch 1 augegebenen Merkmale definiert.

Der Vorteil der erfindungsgemäßen Lösung ist darin zu sehen, daß einerseits die Halbleiteremitter eine einfach aufgebaute und zu betreibende Strahlungsquelle darstellen, und daß andererseits die vorgesehene Vielzahl von Halbleiteremittern der Leuchtreihe die Projektionsoptik insoweit vereinfacht, als diese alle Halbleiteremitter der Leuchtreihe gleichzeitig auf die diesen zugeordneten Bildflecken abbilden kann, so daß die Möglichkeit eröffnet wird, jeden Bildfleck während einer Zeitdauer auszuleuchten, die größer als die bei konventionellen Fernsehgeräten übliche Zeitdauer für das Ausleuchten eines Bildflecks ist, wenn man davon ausgeht, daß das Bild, um als Ganzes für das menschliche Auge erkennbar zu sein, mindestens in dem bei Fernsehgeräten üblichen Zeitraum aufgebaut sein muß und sich mindestens mit bei Fernsehgeräten üblichen Wiederholfrequenzen wiederholen muß.

Dabei besteht die Möglichkeit, beispielsweise die Vielzahl der Halbleiteremitter so zu wählen, daß zu einem Zeitpunkt die Projektionsoptik einen Teil der Bildflecken einer Bildreihe ausleuchtet und zu einem späteren Zeitpunkt einen anderen Teil.

Eine Reihe im Sinne der Erfindung kann horizontal oder vertikal verlaufen.

Besonders vorteilhaft ist es jedoch, wenn die Vielzahl der Halbleiteremitter so groß ist, daß zu einem Zeitpunkt jedem Bildfleck der Bildreihe ein Austrittsfleck eines Halbleiteremitters ausschließlich zugeordnet ist, so daß die Projektionsoptik zu diesem Zeitpunkt sämtlichen Bildflecken mindestens jeweils einen Austrittsfleck durch Abbildung zuordnet und somit die aus dem Stand der Technik bekannte sukzessive Ausleuchtung eines oder mehrerer Bildflecken der Bildreihe entfallen kann.

Besonders zweckmäßig bei der erfindungsgemäßen Lösung ist es, wenn die Halbleiteremitter die Strahlung im Zeitraum zwischen zwei aufeinanderfolgenden Ansteuerzeitpunkten emittieren. Der Vorteil hierbei ist darin zu sehen, daß im Gegensatz zu den aus dem Stand der Technik bekannten Vorrichtungen nicht nur zu einem einzigen Zeitpunkt eine kurze Ausleuchtung eines Bildpunktes erfolgen kann, sondern aufgrund der Tatsache, daß die Projektionsoptik die Vielzahl der Halbleiteremitter den Bildflecken zuordnet, während der gesamten Zeit der Zuordnung die Möglichkeit besteht, die Bildflecken auszuleuchten.

Aus Steuerungsgründen ist es hierbei besonders zweckmäßig, wenn die Ansteuerzeitpunkte in konstanten Zeitabständen aufeinander folgen.

Ein vorteilhaftes Ausführungsbeispiel sieht dabei vor, daß die Halbleiteremitter die Strahlung mit variabel einstellbarer Intensität emittieren, um entsprechend der einstellbaren Intensität die Bildflecken auszuleuchten.

Bei dieser Variante hat es sich als zweckmäßig erwiesen, wenn die Halbleiteremitter zwischen zwei Ansteuerpunkten die Strahlung mit der eingestellten Intensität im wesentlichen unverändert emittieren.

Günstigerweise ist hierzu vorgesehen, daß die Einstellung der Intensität der Strahlung jedes Halbleiteremitters zu jedem Ansteuerzeitpunkt erfolgt und insbesondere beim nächsten Ansteuerzeitpunkt die Möglichkeit besteht, die Intensitätseinstellung zu ändern.

Diese Lösung hat den großen Vorteil, daß der gesamte Zeitraum zwischen zwei aufeinanderfolgenden Ansteuerzeitpunkten zur Verfügung steht, um die den Austrittsflecken dieser Halbleiteremitter zugeordneten Bildflecken auszuleuchten, so daß eine wesentlich geringere Leistung des einzelnen Halbleiteremitters ausreicht, um für das zeitlich mittelnde menschliche Auge eine bestimmte Ausleuchtung eines Bildpunktes zu erreichen, im Gegensatz zu den aus dem Stand der Technik bekannten Lösungen, bei welchen aufgrund des Springens von Bildfleck zu Bildfleck ein sehr kurzer Zeitraum zur Verfügung steht, um diesen Bildfleck auszuleuchten und im zeitlichen Mittel eine gewünschte, vom menschlichen Auge beobachtete Intensität zu erreichen.

Alternativ hierzu ist vorgesehen, daß die Halbleiteremitter zwischen den Ansteuerzeitpunkten entweder die Strahlung mit maximaler Intensität, aber variabel einstellbarer Zeitdauer oder keine Strahlung emittieren. Diese Art der Ansteuerung der Halbleiteremitter hat den Vorteil, daß damit eine einfache, insbesondere für das Betreiben von Halbleiteremittern geeignete Betriebsweise möglich ist.

Insbesondere erfolgt bei einem derartigen Ausführungsbeispiel die Einstellung einer mittleren, von einem menschlichen Beobachter wahrgenommenen Intensität durch Modulation der Zeitdauer der Emission der Strahlung.

Vorzugsweise erfolgt dabei die Einstellung der Zeitdauer der Emission der Strahlung zu jedem Ansteuerzeitpunkt, so daß die im Mittel durch einen menschlichen Beobachter erkannte Intensität ständig unterschiedlich einstellbar ist.

Auch bei diesem Ausführungsbeispiel besteht der Vorteil darin, daß eine wesentlich größere Zeitdauer für die Ausleuchtung zur Verfügung steht, da im Maximalfall die gesamte Zeitdauer zwischen zwei Ansteuerpunkten für das Erreichen der gewünschten mittleren Intensität zur Verfügung steht.

Hinsichtlich der Ausleuchtung der Bildflecken durch die Halbleiteremitter wurden bislang keine näheren Angaben gemacht. So ist im einfachsten Fall vorgesehen, daß jeder Bildfleck durch einen einzigen Halbleiteremitter ausleuchtbar ist. Damit ist aber lediglich ein einfarbiges Bild erzeugbar.

Um ein mehrfarbiges Bild erzeugen zu können, ist vorzugsweise vorgesehen, daß jeder Bildfleck durch drei Halbleiteremitter ausleuchtbar ist, von denen jeder Strahlung mit einer derartiger Wellenlänge emittiert, daß durch Überlagerung der Strahlung der drei Halbleiteremitter weißes Licht erzeugbar ist.

Hinsichtlich der Ansteuerung bei drei einen Bildfleck ausleuchtenden Halbleiteremittern ist vorzugsweise vorgesehen, daß die drei jeweils einen Bildfleck ausleuchtenden Halbleiteremitter gleichzeitig ansteuerbar sind, um sicherzustellen, daß stets die gewünschte Farbe im ausgeleuchteten Bildfleck erkennbar ist.

Hinsichtlich des Aufbaus der Leuchtreihe wurden damit noch keine näheren Angaben gemacht. So ist unabhängig von der Frage, ob ein Bildfleck durch einen oder durch drei Halbleiteremitter ausleuchtbar ist, vorteilhafterweise vorgesehen, daß die Leuchtreihe mindestens eine Reihe von Halbleiteremittern aufweist, die Strahlung derselben Wellenlänge emittieren, da eine derartige Leuchtreihe besonders einfach, beispielsweise durch ein sogenanntes "Array" von Halbleiteremittern herstellbar ist.

In dem Fall, in dem ein mehrfarbiges Bild erzeugt werden soll, ist vorteilhafterweise vorgesehen, daß zur Ausleuchtung der Bildflecken einer Bildreihe die entsprechende Leuchtreihe drei parallel zueinander verlaufende Reihen von Halbleiteremittern umfaßt, wobei die Halbleiteremitter jeder Reihe Strahlung mit im wesentlichen derselben Wellenlänge emittieren. Eine derartige Zusammenfassung der Halbleiteremitter, die Strahlung derselben Wellenlänge emittieren, ist ebenfalls aus Gründen der Herstellbarkeit derselben in Form eines sogenannten "Arrays" vorteilhaft.

Hinsichtlich der Art der Ansteuerung der Halbleiteremitter wurden bislang keine weiteren Angaben gemacht. So sieht ein vorteilhaftes Ausführungsbeispiel vor, daß von den Halbleiteremittern einer Leuchtreihe mindestens diejenigen zu demselben Ansteuerzeitpunkt ansteuerbar sind, die einem Zehntel der Bildflecken einer Bildreihe zugeordnet sind. Damit wird eine signifikante Verlängerung der Zeit zur Ansteuerung der Halbleiteremitter erreicht.

Noch vorteilhafter ist es, wenn von jeder Leuchtreihe mindestens diejenigen Halbleiteremitter gleichzeitig ansteuerbar sind, welche einem Drittel der Bildflecken einer Bildreihe zugeordnet sind.

Noch besser ist es, wenn die allen Bildflecken einer Bildreihe zugeordneten Halbleiteremitter gleichzeitig ansteuerbar sind.

Wie die gleichzeitige Ansteuerung mehrerer Halbleiteremitter realisiert ist, wurde bislang nicht im einzelnen erläutert. So sieht ein vorteilhaftes Ausführungsbeispiel vor, daß zur gleichzeitigen Ansteuerung mehrerer Halbleiteremitter ein Zwischenspeicher vorgesehen ist, aus welchem die Ansteuerparameter zur gleichzeitigen Ansteuerung der mehreren Halbleiteremitter parallel auslesbar sind.

Vorzugsweise ist zur Abspeicherung der Ansteuerparameter vorgesehen, daß der Zwischenspeicher zwischen den Ansteuerzeitpunkten die Ansteuerparameter für die Halbleiteremitter aufnimmt.

Vorzugsweise ist dabei vorgesehen, daß die Ansteuerparameter in den Zwischenspeicher seriell einlesbar sind.

Die Erzeugung der Ansteuerparameter erfolgt im einfachsten Fall durch einen Bildgenerator. Vorzugsweise ist der Bildgenerator so konzipiert, daß dieser die Ansteuerparameter seriell generiert und in den Zwischenspeicher einliest.

Um die Möglichkeit zu schaffen, die Halbleiteremitter zwischen zwei Ansteuerzeitpunkten definiert anzusteuern, ist vorzugsweise vorgesehen, daß jedem Halbleiteremitter eine Ansteuerung zugeordnet ist, welche den Ansteuerparameter von einem Ansteuerzeitpunkt bis zum nächsten Ansteuerzeitpunkt zwischenspeichert.

Hinsichtlich der Ausbildung der Projektionsoptik wurden bislang keine näheren Angaben gemacht. So sieht ein vorteilhaftes Ausführungsbeispiel vor, daß die Projektionsoptik eine Leuchtreihe sukzessive auf mehrere Bildreihen abbildet. Diese Lösung hat den Vorteil, daß nur eine Leuchtreihe erforderlich ist, um ein zweidimensionales Bild, bestehend aus mehreren Bildreihen, zu erzeugen.

Eine derartige Projektionsoptik läßt sich vorteilhafterweise dadurch realisieren, daß diese ein strahlumlenkendes Element umfaßt, welches die Leuchtreihe in aufeinanderfolgende Bildreihen abbildet.

Vorzugsweise ist hierbei das strahlumlenkende Element ein bewegbares Reflexionselement.

Dieses Reflexionselement ist vorzugsweise derart bewegbar, daß dieses in die Leuchtreihe in jeweils eine Bildreihe abbildende definierte Winkelpositionen bewegbar ist.

Eine mögliche Lösung wäre die Verwendung eines Kippspiegels.

Ein besonders zweckmäßiges Ausführungsbeispiel sieht vor, daß das strahlumlenkende Element durch einen rotierenden Polygonspiegel gebildet ist.

Mit einem derartigen Polygonspiegel ist eine sukzessive Abbildung der Leuchtreihe in mehrere Bildreihen besonders einfach dadurch realisierbar, daß der Polygonspiegel mit konstanter Drehzahl rotiert.

Hierbei ist vorzugsweise vorgesehen, daß der Polygonspiegel mit jeder Polygonfläche die Zahl der Bildreihen durch Drehung in einem bestimmten Winkelbereich durchläuft und dann zur nächsten Polygonfläche übergeht.

Besonders vorteilhaft funktioniert die Erzeugung des Bildes mit einem strahlumlenkenden Element, wenn die Projektionsoptik die Strahlung der Halbleiteremitter der Leuchtreihe im wesentlichen auf das strahlumlenkende Element fokussiert.

Bei all den Ausführungsbeispielen, bei welchen aus einer Leuchtreihe mehrere Bildreihen durch die Projektionsoptik erzeugt werden, ist vorteilhafterweise vorgesehen, daß zur Ausleuchtung der Bildflecken einer Bildreihe ein Zeitraum von mindestens ungefähr 1 µs, vorteilhafterweise mindestens ungefähr 5 µs, vorzugsweise mindestens ungefähr 10 µs, zur Verfügung steht.

In dem Fall, in welchem alle den Bildflecken einer Bildreihe zugeordneten Halbleiteremitter gleichzeitig angesteuert werden, bedeutet dies, daß die Zeitintervalle zwischen zwei Ansteuerzeitpunkten ebenfalls mindestens ungefähr 1 µs, vorteilhafterweise mindestens ungefähr 5 µs, vorzugsweise mindestens ungefähr 10 µs, betragen. Werden nur die einem Teil der Bildpunkte zugeordneten Halbleiteremitter gleichzeitig angesteuert, so multipliziert sich diese Zahl mit dem Bruchteil der gleichzeitig ausgeleuchteten Bildflecken der Bildreihe. Im Fall von mindestens einem Zehntel der Bildpunkte stehen mindestens ungefähr 0,1 µs, vorteilhafterweise mindestens ungefähr 0,5 µs, vorzugsweise mindestens ungefähr 1 µs, als Intervall zwischen zwei Ansteuerzeitpunkten zur Verfügung.

Alternativ zu dem Fall, daß die Projektionsoptik eine Leuchtreihe sukzessive auf mehrere Bildreihen abbildet, ist vorgesehen, daß jeder Bildreihe eine Leuchtreihe zugeordnet ist.

In diesem Fall ist die Projektionsoptik so ausgebildet, daß sie die Vielzahl von Leuchtreihen auf die Vielzahl von Bildreihen abbildet.

Ganz generell wurden zur Art der Abbildungsqualität der Projektionsoptik keinerlei nähere Angaben gemacht. So sieht ein vorteilhaftes Ausführungsbeispiel vor, daß die Projektionsoptik durch Vergrößerung der Austrittsflecken in Längsrichtung der Bildreihe geringe Abstände voneinander aufweisende Bildflecken erzeugt.

Vorzugsweise ist dabei vorgesehen, daß die Bildflecken im wesentlichen aneinander angrenzen.

Die Erfindung betrifft insbesondere auch eine Vorrichtung zur Erzeugung mehrfarbiger Bilder durch Ausleuchtung unterschiedlicher Bildflecken mit unterschiedlichen Farben, wobei der für das menschliche Auge erkennbare Farbeindruck durch beliebige Mischung von drei Grundfarben, beispielsweise Mischung von Blau, Grün und Rot, entsteht.

Insbesondere dient die erfindungsgemäße Vorrichtung nicht nur zur Erzeugung mehrfarbiger statischer sondern auch mehrfarbiger bewegter Bilder.

Bei Verwendung von drei mit unterschiedlicher Wellenlänge strahlenden Halbleiteremittern zur farbigen Ausleuchtung eines Bildflecks bei der Erzeugung eines für das menschliche Auge farbig erscheinenden Bildes mit wechselnden Farben ist vorzugsweise vorgesehen, daß die Projektionsoptik die Strahlung der drei mit unterschiedlicher Wellenlänge strahlenden Halbleiteremitter auf einen Bildfleck abbildet.

Hierbei ist es günstig, wenn die Projektionsoptik die Strahlung der drei mit unterschiedlicher Wellenlänge strahlenden Halbleiteremitter zu einem Strahlenbündel vereinigt, um die Abbildung zu vereinfachen.

Die Strahlung der drei jeweils mit unterschiedlichen Wellenlängen emittierenden und die Farbe eines Bildflecks bestimmenden Halbleiteremitter ist vorzugsweise vor Auftreffen auf dem Umlenkelement zu einem Strahlenbündel zusammengefaßt, welches dann von dem Umlenkelement von einem Bildfleck zum nächsten bewegt wird.

Alternativ dazu ist es aber auch denkbar, daß die Strahlung der drei mit unterschiedlicher Wellenlänge emittierenden Halbleiteremitter getrennt auf das Umlenkelement trifft und anschließend von der Projektionsoptik auf einen einzigen Bildfleck abgebildet wird, wobei in diesem Fall die Projektionsoptik so ausgebildet sein muß, daß sie die Strahlung der drei Halbleiteremitter bei allen von diesen auszuleuchtenden Bildflecken auf diese abbildet.

Alternativ dazu ist vorgesehen, daß die Projektionsoptik die Strahlung der drei mit unterschiedlicher Wellenlänge strahlenden Halbleiteremitter in drei nicht deckungsgleich angeordnete Teilbildflecken abbildet.

Diese Lösung ist insoweit einfacher, als der Aufwand einer deckungsgleichen Abbildung der Strahlung mit unterschiedlicher Wellenlänge zur Erzeugung der Bildflecken entfällt und insoweit ausreichend, als die Teilbildflecken klein genug sind, um für das menschliche Auge als ein Bildfleck mit einer Farbe zu erscheinen.

Bei diesem Ausführungsbeispiel ist vorteilhafterweise vorgesehen, daß die Strahlung der drei jeweils mit unterschiedlicher Wellenlänge emittierenden und die Farbe eines Bildflecks bestimmenden Halbleiteremitter getrennt auf das Umlenkelement trifft, so daß dieses die Strahlung auch getrennt umlenkt.

Hinsichtlich der Halbleiteremitter wurden bislang keine näheren Angaben gemacht. Grundsätzlich ist es möglich, als Halbleiteremitter Halbleiterleuchtdioden oder auch Superstrahler oder Elektrolumineszenz-Elemente einzusetzen.

Als besonders vorteilhaft hat es sich erwiesen, wenn die Halbleiteremitter Halbleiterlaser umfassen.

Hierzu sind besonders zweckmäßige Typen sogenannte Kantenemitter, da sich diese in einfacher und insbesondere kostengünstiger Weise als sogenannte "Arrays", das heißt Reihen von Halbleiteremittern auf einem Substrat, herstellen lassen. Diese Kantenemitter eignen sich auch gut für nachgeordnete Frequenzvervielfacher.

Alternativ dazu ist es aber auch vorteilhaft, wenn die Halbleiteremitter sogenannte Vertikalemitter sind, die sich ebenfalls in einfacher Weise in Form einer Matrix anordnen lassen und bei welchen insbesondere eine Ankopplung faseroptischer Elemente, beispielsweise von Frequenzverdopplern, möglich ist.

Insbesondere in den Fällen, in denen zur vorteilhaften Erzeugung von Strahlung der gewünschten Wellenlänge, beispielsweise der Farben Blau, Grün oder Rot, die Verwendung einer Halbleiterstrahlungsquelle kombiniert mit einem Frequenzverdoppler günstig erscheint, umfaßt ein erfindungsgemäßer Halbleiteremitter eine Halbleiterstrahlungsquelle, insbesondere einen Halbleiterlaser, und einen Frequenzverdoppler für die von der Halbleiterstrahlungsquelle emittierte Strahlung.

Vorzugsweise ist dabei der Frequenzverdoppler so aufgebaut, daß er eine die Strahlung jeder Strahlungsquelle auf eine Leistungsdichte von mindestens 10⁵W/cm² komprimiert führende oder komprimierende Wellenleiterstruktur und ein in der Wellenleiterstruktur angeordnetes frequenzverdoppelndes Medium umfaßt.

Das Vorsehen einer derartigen Wellenleiterstruktur ermöglicht es in einfacher Weise, die hohe, für die Frequenzverdopplung erforderliche Leistungsdichte in dem frequenzverdoppelnden Medium über eine ausreichende Wechselwirkungslänge aufrecht zu erhalten.

Der Frequenzverdoppler kann dabei in unterschiedlichster Art und Weise relativ zur Strahlungsquelle angeordnet sein. So sieht ein vorteilhaftes Ausführungsbeispiel vor, daß zwischen jeder Strahlungsquelle und jedem Frequenzverdoppler eine die Strahlung in die Wellenleiterstruktur fokussierende Optik angeordnet ist, um zu erreichen, daß die gesamte divergierend aus der Strahlungsquelle austretende Strahlung in die Wellenleiterstruktur eingekoppelt wird.

Alternativ dazu ist vorgesehen, daß jeder Frequenzverdoppler sich unmittelbar an die jeweilige Strahlungsquelle anschließt. In diesem Fall ist ebenfalls sichergestellt, daß die von der Strahlungsquelle erzeugte Strahlung im wesentlichen in den nachgeordneten Frequenzverdoppler eintritt, insbesondere dann, wenn dessen Wellenleiterstruktur an die Querschnittsform der aus der Strahlungsquelle austretenden Strahlung angepaßt ist.

Dieses Ausführungsbeispiel hat außerdem den Vorteil, daß das Vorsehen und Justieren einer fokussierenden Optik zwischen der Strahlungsquelle und dem Frequenzverdoppler entfallen kann.

Bei einem zweckmäßigen Ausführungsbeispiel ist vorgesehen, daß die Strahlungsquellen einer Leuchtreihe in einer Reihe angeordnet sind und die Frequenzverdoppler der Leuchtreihe ausgangsseitig der Strahlungsquellen in ebenfalls einer Reihe, vorzugsweise mit denselben Abständen wie die Strahlungsquellen, angeordnet sind.

Vorzugsweise lassen sich die Strahlungsquellen dann besonders einfach und kostengünstig herstellen, wenn mehrere der Strahlungsquellen auf einem gemeinsamen Substrat angeordnet sind.

In gleicher Weise lassen sich auch die Frequenzverdoppler dann kostengünstig herstellen, wenn mehrere Frequenzverdoppler auf einem gemeinsamen Substrat angeordnet sind.

Insbesondere läßt sich eine Vielzahl von Strahlungsquellen und eine Vielzahl von Frequenzverdopplern dann ideal kombinieren, wenn diese jeweils auf einem gemeinsamen Substrat in jeweils denselben Abständen sitzen, so daß damit die Möglichkeit besteht, die Frequenzverdoppler unmittelbar im Anschluß an die Strahlungsquellen oder mit einer dazwischen geschalteten Fokussierungsoptik anzuordnen, wobei jedoch stets sowohl Strahlungsquelle als auch Frequenzverdoppler auf einer gemeinsamen optischen Achse sitzen.

Hinsichtlich der Art und Ausbildung der Wellenleiterstruktur wurden bislang keine näheren Angaben gemacht. So sieht ein vorteilhaftes Ausführungsbeispiel vor, daß die Wellenleiterstruktur jedes Frequenzverdopplers ein single-mode-Wellen-leiter ist.

Hinsichtlich der Ausbildung der Wellenleiterstruktur selbst wurden im Zusammenhang mit der bisherigen Beschreibung einzelner Ausführungsbeispiele keine weiteren Angaben gemacht. So sieht ein vorteilhaftes Ausführungsbeispiel vor, daß die Wellenleiterstruktur durch ein das den Wellenleiterkern bildende, frequenzverdoppelnde Medium umgebendes und einen niedrigeren Brechungsindex als der Wellenleiterkern aufweisendes Wandmaterial gebildet ist. Auf diese Art und Weise läßt sich in einfacher Weise die Wellenleiterstruktur mit den gewünschten Abmessungen herstellen.

Vorzugsweise ist dabei vorgesehen, daß das Wandmaterial auf demselben Material wie das frequenzverdoppelnde Medium basiert und aufgrund unterschiedlicher Dotierung einen niedrigeren Brechungsindex als dieses aufweist um an den Grenzflächen zwischen dem Wandmaterial und dem frequenzverdoppelnden Medium eine Führung der Strahlung zu erhalten.

Die derartige Herstellung einer Wellenleiterstruktur ist in unterschiedlichster Art und Weise möglich. Ein vorteilhaftes Ausführungsbeispiel sieht vor, daß die Wellenleiterstruktur durch Dotierung von das Wandmaterial bildenden Bereichen in einem mit dem frequenzverdoppelnden Medium identischen Material gebildet ist. Dieses Ausführungsbeispiel schafft die Möglichkeit, ausgehend von dem Material des frequenzverdoppelnden Mediums in einfacher Weise den Wellenleiter durch Dotierung der Bereiche zu erreichen, welche das Wandmaterial für den Wellenleiter bilden sollen.

Eine derartige Dotierung ist beispielsweise durch Diffusion von Dotierungselementen möglich. Besonders vorteilhaft lassen sich derartige dotierte Bereiche dann herstellen, wenn die Wellenleiterstruktur durch auf einem vorzugsweise einkristallinen Substrat aufgetragene und das Wandmaterial umfassende Schichten gebildet ist.

In gleicher Weise läßt sich in einfacher Weise das frequenzverdoppelnde Medium dann herstellen, wenn dieses durch eine auf einem Substrat aufgetragene Schicht gebildet ist.

Vorzugsweise ist das Substrat ebenfalls aus dem Material des frequenzverdoppelnden Mediums.

Insbesondere hat die Verwendung eines Substrats den Vorteil, daß eine definierte Ausrichtung von optischen Achsen des frequenzverdoppelnden Mediums durch Ausrichtung des Substrats vorgebbar ist, sofern dieses Substrat auf dem Material basiert, welches auch für das frequenzverdoppelnde Medium vorgesehen ist.

Um die für die Frequenzverdopplung erforderliche Phasenanpassung zu erreichen, ist vorzugsweise vorgesehen, daß das frequenzverdoppelnde Medium so ausgebildet und hinsichtlich seiner optischen Achsen zum Wellenleiterkanal so ausgerichtet ist, daß eine unkritische Phasenanpassung zwischen der von der Strahlungsquelle erzeugten und eingekoppelten Strahlung und der frequenzverdoppelten Strahlung in Längsrichtung der Wellenleiterstruktur erfolgt.

Vorzugsweise ist dabei zur Durchführung dieser Phasenanpassung vorgesehen, daß das frequenzverdoppelnde Medium auf eine definierte Temperatur bringbar und auf dieser haltbar ist, so daß die optimale Phasenanpassung nach einmaliger Einstellung der Temperatur aufrecht erhalten werden kann.

Alternativ dazu ist bei einem vorteilhaften Ausführungsbeispiel vorgesehen, daß das frequenzverdoppelnde Medium so ausgebildet und ausgerichtet ist, daß in Längsrichtung des Wellenleiters eine Quasiphasenanpassung erfolgt.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: eine schematische Draufsicht auf ein erstes Ausführungsbeispiel einer erfindungsgemäßen Vorrichtung;
- Fig. 2: eine schematische Seitenansicht des ersten Ausführungsbeispiels gemäß Fig. 1 mit überproportional vergrößerter Darstellung der optischen Abbildung und schematischer Darstellung der Steuerung;
- Fig. 3: eine schematische Darstellung eines Verlaufs der Intensität der Strahlung eines Halbleiteremitters nach verschiedenen Ansteuerzeitpunkten;
- Fig. 4: eine schematische Darstellung einer Variante der Steuerung des ersten Ausführungsbeispiels gemäß Fig. 2;
- Fig. 5: eine schematische Darstellung des Verlaufs der Intensität der Strahlung eines Halbleiteremitters nach verschiedenen Ansteuerzeitpunkten;
- Fig. 6: eine schematische perspektivische Darstellung eines zweiten Ausführungsbeispiels;
- Fig. 7: eine ausschnittsweise vergrößerte Darstellung einer Synchronisation zwischen einem Polygonspiegel und der Steuerung beim zweiten Ausführungsbeispiel;
- Fig. 8: eine schematische Darstellung des Intensitätsverlaufs ähnlich Fig. 4 bei Verwendung der Steuerung des zweiten Ausführungsbeispiels;
- Fig. 9: eine schematische Darstellung des Intensitätsverlaufs ähnlich Fig. 5 bei Verwendung der Variante der im Zusammenhang mit dem ersten Ausführungsbeispiel beschriebenen Steuerung;
- Fig. 10: eine schematische Darstellung eines dritten Ausführungsbeispiels der erfindungsgemäßen Vorrichtung;
- Fig. 11: eine schematische Darstellung eines vierten Ausführungsbeispiels der erfindungsgemäßen Vorrichtung;
- Fig. 12: eine schematische Darstellung eines fünften Ausführungsbeispiels der erfindungsgemäßen Vorrichtung;
- Fig. 13: eine schematische Darstellung eines sechsten Ausführungsbeispiels der erfindungsgemäßen Vorrichtung;
- Fig. 14: eine schematische Darstellung eines siebten Ausführungsbeispiels der erfindungsgemäßen Vorrichtung;
- Fig. 15: eine schematische Darstellung eines als Kantenemitter ausgebildeten Halbleiteremitters;
- Fig. 16: eine schematische Darstellung eines als Vertikalemitter ausgebildeten Halbleiteremitters;
- Fig. 17: eine Draufsicht auf ein erstes Ausführungsbeispiel eines Arrays aus Halbleiteremittern, umfassend Strahlungsquellen und nachgeordnete Frequenzverdoppler;
- Fig. 18: eine perspektivische Explosionsdarstellung des Arrays von Strahlungsquellen und des Arrays von Frequenzverdopplern gemäß Fig. 17;
- Fig. 19: eine Variante des Arrays von Frequenzverdopplern gemäß dem ersten Ausführungsbeispiel;
- Fig. 20: ein zweites Ausführungsbeispiel eines Arrays von Halbleiteremittern, gebildet aus Strahlungsquellen und Frequenzverdopplern sowie einer dazwischen geschalteten Optik.

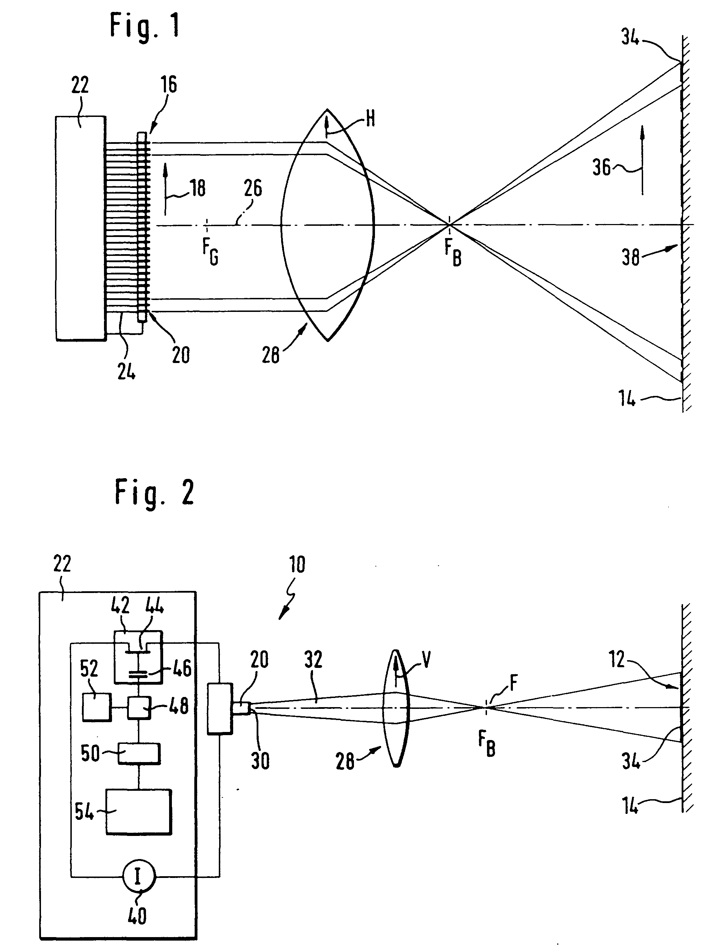

Ein in Fig. 1 und 2 dargestelltes erstes einfachstes Ausführungsbeispiel einer erfindungsgemäßen Vorrichtung, als Ganzes mit 10 bezeichnet, zur Erzeugung eines Bildes 12 auf einer Bildfläche 14 - beispielsweise einer Projektionsfläche, auf welcher das Bild für ein menschliches Auge erkennbar erzeugt wird - umfaßt eine Vielzahl von in einer Leuchtreihe 16 entlang einer Längsrichtung 18 der Leuchtreihe 16 angeordneten Halbleiteremittern 20, welche jeweils einzeln von einer gemeinsamen Steuerung 22 über einzelne Steuerleitungen 24 ansteuerbar sind.

Die Längsrichtung 18 verläuft dabei quer zu einer optischen Achse 26 einer als Ganzes mit 28 bezeichneten Projektionsoptik, welche einen Austrittsfleck 30 jedes Halbleiteremitters 20, aus welchem von diesem erzeugte Strahlung 32 austritt, auf einen Bildfleck 34 der Bildfläche 14 abbildet, welcher von der von dem Halbleiteremitter 20 erzeugten Strahlung dann ausgeleuchtet ist. Die Projektionsoptik 28 ist dabei so aufgebaut, daß der Austrittsfleck 30 jedes Halbleiteremitters 20 zu einem bestimmten Zeitpunkt nur auf einen einzigen Bildfleck 34 in der Bildfläche 14 projiziert wird.

Im einfachsten Fall ist die Projektionsoptik 28, wie in Fig. 1 und 2 schematisch dargestellt, eine Linse, welche mit der aus dem Halbleiteremitter 20 mit geringfügiger Divergenz austretenden Strahlung 32 aufgrund geometrischer Abbildung den Bildfleck 34 ausleuchtet, wobei der Bildfleck 34 in der Regel eine Fläche aufweist, die einem Mehrfachen des Austrittsflecks 30 entspricht.

Im einfachsten Fall, in welchem die Leuchtreihe 16 aus einzelnen, in der Längsrichtung 18 nebeneinander angeordneten Halbleiteremittern besteht und die Projektionsoptik 28 eine einfache Linse darstellt, entstehen auf der Bildfläche 14 in einer Längsrichtung 36 nebeneinanderliegende einzelne Bildflecken 34, die insgesamt eine Bildreihe 38 bilden. Vorzugsweise ist die Projektionsoptik 28 so ausgebildet, daß sich die einzelnen Bildflecken 34 der Bildreihe 38 in Richtung der Längsrichtung 36 nicht überlappen. Besonders bevorzugt ist eine Ausführungsform der Projektionsebene, in welcher die Bildflecken 34 mit ihren äußeren Berandungen in geringem Abstand aufeinanderfolgen oder aneinander angrenzen.

Zur Variation der Helligkeit der Bildflecken 34 für das das Bild 12 beobachtende menschliche Auge umfaßt die Steuerung 22, wie in Fig. 2 dargestellt, eine für alle Halbleiteremitter 20 gemeinsame Stromquelle 40, welche einen für jeden Halbleiteremitter 20 vorgesehenen Stromsteuerblock versorgt, der beispielsweise einen FET-Transistor 44 als stromsteuerndes Element umfaßt, an dessen Gate als Speicherelement ein Kondensator 46 angeschlossen ist. Dieser Kondensator 46 jedes Stromsteuerblocks 42 ist über einen Ansteuerschalter 48 mit einer bestimmten Ladung aufladbar, wobei die Ladung im Kondensator 46 den Strom durch den FET-Transistor 44 festlegt. Die in dem Kondensator 46 zu speichernde Ladung wird dabei aus einem Zwischenspeicher 50 für jeden Kondensator 46 jedes Stromsteuerblocks 42 durch Triggern des Ansteuerschalters 48 aus dem Zwischenspeicher 50 ausgelesen, wobei vorzugsweise der Zwischenspeicher 50 alle Ansteuerparameter speichert und durch Triggern des Ansteuerschalters 48 alle Ansteuerparameter gleichzeitig in die Kondensatoren 46 aller Stromsteuerblocks 42 eingelesen werden.

Zum Triggern des Ansteuerschalters 48 ist ein Triggerblock 52 vorgesehen.

Zwischen den Zeitpunkten t, zu welchen der Triggerblock 52 den Ansteuerschalter 48 triggert, besteht die Möglichkeit, über einen Bildgenerator 54 die einzelnen Ansteuerparameter seriell in den Zwischenspeicher 50 einzulesen, so daß zu jedem Triggerzeitpunkt t der Zwischenspeicher 50 die aktuellen Ansteuerparameter für die gesamten Halbleiteremitter 20 der Leuchtreihe 16 gespeichert hat.

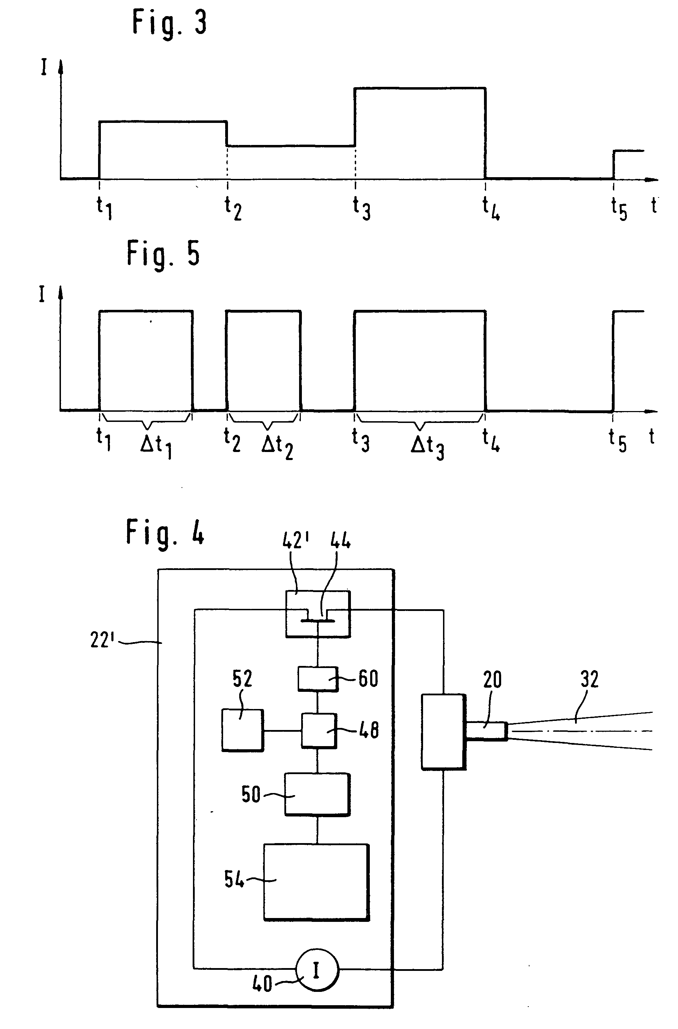

Betrachtet man nun einen Halbleiteremitter 20, so kann die Intensität der von diesem ausgesandten Strahlung 32, wie in Fig. 3 dargestellt, zum Ansteuerzeitpunkt t₁ durch entsprechendes Laden des Kondensators 46 des entsprechenden Steuerblocks 42 festgelegt werden. Die Ladung bleibt danach im Kondensator 46 erhalten, so daß die Intensität der Strahlung des Halbleiteremitters bis zum nächsten Ansteuerzeitpunkt t₂ konstant bleibt. Wird zu diesem Zeitpunkt die Ladung im Kondensator 46 erniedrigt, so bleibt bis zum nächsten Ansteuerzeitpunkt t₃ auch diese Intensität erhalten. Zum Ansteuerzeitpunkt t₃ wird beispielsweise die maximale Intensität und somit die maximale Ladung in dem Kondensator 46 gespeichert, während zum Ansteuerzeitpunkt t₄ die minimale Ladung gespeichert wird, so daß der Halbleiteremitter 20 keine Strahlung oder Strahlung mit der Intensität 0 zwischen dem Ansteuerzeitpunkt t₄ und t₅ aussendet.

Dadurch daß für jeden Halbleiteremitter 20 ein eigener Steuerblock 42 vorgesehen ist, kann nun jeder einzelne Halbleiteremitter 20 der Leuchtreihe 16 einzeln angesteuert werden, so daß die Bildreihe 38 Bildflecken 34 unterschiedlichster Intensität aufweist.

Bei einem alternativen Ausführungsbeispiel der erfindungsgemäßen Steuerung 22', dargestellt in Fig. 4 sind diejenigen Komponenten, die mit der Steuerung 22 identisch sind, mit denselben Bezugszeichen versehen, so daß bezüglich deren Beschreibung auf die Ausführungen zur Steuerung 22 vollinhaltlich Bezug genommen wird.

Im Gegensatz zur Steuerung 22 umfaßt jeder Steuerblock 42' lediglich den Steuertransistor 44, dessen Gate durch eine Pulsformerstufe 60 angesteuert wird und der lediglich zwischen den Zuständen ein und aus geschaltet wird. Die Pulsformerstufe speichert ihrerseits die zum jeweiligen Ansteuerzeitpunkt t übermittelten Ansteuerparameter und formt entsprechend den Ansteuerparametern einen Steuerpuls unterschiedlicher Länge für den Steuertransistor 44 nach dem Prinzip der Pulsweitenmodulation, so daß auch der Halbleiteremitter 20 entweder ein- oder ausgeschaltet ist, allerdings mit unterschiedlich langer Dauer zwischen den jeweiligen Ansteuerzeitpunkten t, wie in Fig. 5 dargestellt.

Die konstanten Intensitätswerte zwischen den Ansteuerpunkten t1, t2, t3 und t4 werden durch unterschiedlich lange Pulsdauern Δ t₁, Δ t₂, Δ t₃ realisiert, wobei der Halbleiteremitter während der Pulsdauern Δ t₁, Δ t₂ und Δ t₃ jeweils Strahlung 32 mit der maximalen Leistung aussendet. Hierbei wird der Effekt zunutze gemacht, daß das menschliche Auge bei Betrachten des Bildfleckes 34 eine zeitliche Mittelung vornimmt und somit die unterschiedlichen Pulsweiten Δ t₁, Δ t₂ und Δ t₃ den Eindruck im menschlichen Auge vermitteln, wie wenn die in Fig. 3 dargestellten Intensitätswerte während des gesamten Zeitraums zwischen den Ansteuerzeiten t₁, t₂, t₃ und t₄ vorliegen würden.

Im übrigen ist die Steuerung 22' mit der Steuerung 22 identisch aufgebaut.

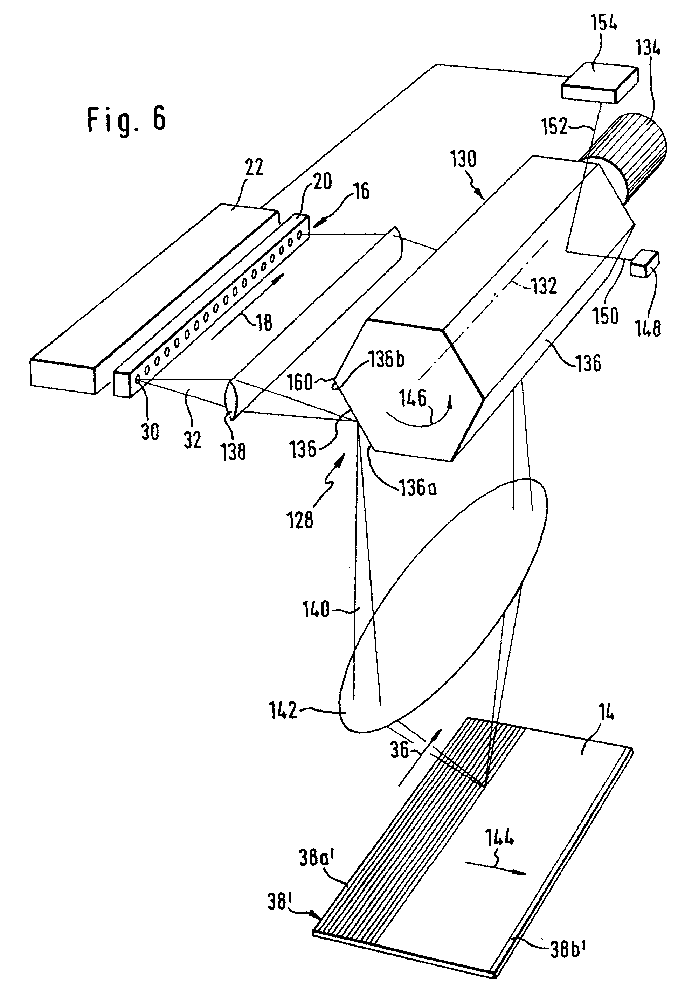

Bei einem zweiten Ausführungsbeispiel, dargestellt in Fig. 6, umfaßt die als Ganzes mit 128 bezeichnete Projektionsoptik einen Polygonspiegel 130, welcher um eine Achse 132 rotierend durch einen Antrieb 134 angetrieben ist. Der Polygonspiegel 130 weist seinerseits eine Vielzahl von in gleichen Winkelabständen um die Achse 132 angeordneten Polygonflächen 136 auf, wobei jeweils eine der Polygonflächen 136 als Reflexionsfläche dient.

Die Leuchtreihe 16 umfaßt genau wie beim ersten Ausführungsbeispiel eine Vielzahl in der Längsrichtung 18 aufeinanderfolgend angeordneter Halbleiteremitter 20, die ebenfalls durch eine Steuerung 22 oder 22' angesteuert sind.

Die aus den Austrittsflecken 30 austretende Strahlung 32 wird zunächst durch eine erste Fokussierungsoptik 138 auf die in Reflexionsstellung stehende Polygonfläche 136 fokussiert, und die von der in Reflexionsstellung stehenden Polygonfläche 136 reflektierte Strahlung 140 wird durch eine zweite Fokussierungsoptik 142 zwischenfokussiert und auf der Bildfläche 14 abgebildet.

Dadurch, daß die in Reflexionsstellung stehende Polygonfläche 136 sich, während sie von der Strahlung 32 angestrahlt wird, um die Achse 132 dreht, entsteht auf der Bildfläche 14 nicht nur eine Bildreihe 38, sondern es entsteht eine Vielzahl von Bildreihen 38', die in einer senkrecht zur Längsrichtung 36 verlaufenden Querrichtung 144 nebeneinander angeordnet sind. Dabei wird eine erste Bildreihe 38a' dann auf der Bildfläche 14 erzeugt, wenn die in Reflexionsstellung stehende Polygonfläche 136 mit ihrem in Drehrichtung vordersten Bereich 136a von der Strahlung 32 beaufschlagt wird, und die letzte Bildreihe 38b' wird dann erzeugt, wenn die in Reflexionsstellung stehende Polygonfläche 136 mit ihrem in Drehrichtung 146 des Polygonspiegels 130 hintersten Bereich 136b von der Strahlung 32 beaufschlagt wird.

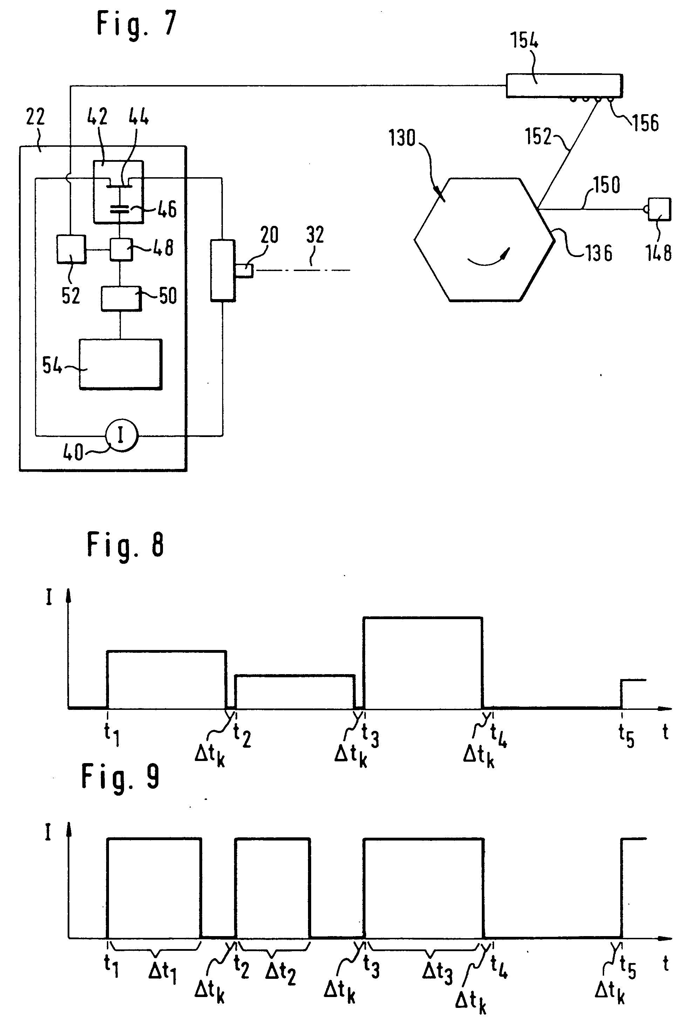

Zur Synchronisation des rotierenden Polygonspiegels 130 mit der Steuerung 22 ist, wie in Fig. 6 und 7 dargestellt, ein weiterer Halbleiteremitter 148 vorgesehen, welcher mit einem Lichtstrahl 150 beispielsweise die der in Reflexionsstellung stehenden Polygonfläche 136 gegenüberliegende Polygonfläche 136 beleuchtet, wobei die reflektierte Strahlung 152 auf einen als Ganzes mit 154 bezeichneten Detektor trifft, welcher einen Detektorbereich 156 oder mehrere Detektorbereiche 156 aufweist, wobei die Detektorbereiche 156 eine Ausdehnung haben, welche ungefähr den Querschnitt der reflektierten Strahlung 152 entspricht, so daß beim Auftreffen der reflektierten Strahlung 152 auf dem jeweiligen Detektorbereich 156 eine genaue Winkelstellung des Polygonspiegels 130 festgelegt ist.

Beispielsweise ist der erste Detektorbereich 156 so positioniert, daß bei Auftreffen der reflektierten Strahlung 152 auf diesem die in Reflexionsstellung stehende Polygonfläche 136 die Austrittsflecken 30 der Halbleiteremitter 20 der Leuchtreihe 16 auf die erste Bildreihe 38'a abbildet. Ferner ist vorzugsweise die zweite Detektorfläche 156 so angeordnet, daß bei Auftreffen der reflektierten Strahlung 152 auf dieser die in Reflexionsstellung stehende Polygonfläche 136 die Austrittsflecken 30 der Halbleiteremitter 20 der Leuchtreihe 16 auf die zweite Bildreihe 38' abbildet und so weiter.

Das Auftreffen der reflektierten Strahlung 152 auf einem der Detektorbereiche 156 erzeugt im Detektor 154 ein Signal, welches beispielsweise dem Triggerblock 52 zugeleitet wird und diesen veranlaßt, gegebenenfalls mit entsprechendem Zeitversatz, den Ansteuerschalter 48 zu triggern, so daß zu diesen Ansteuerzeitpunkten t der Ansteuerparameter für jeden Stromsteuerblock 42 geändert werden kann. Damit besteht die Möglichkeit, auf jede Bildzeile 38' Bildflecken 34 mit unterschiedlicher Intensitätsverteilung zu projizieren und somit auf der Bildfläche 14 ein sich in Längsrichtung 36 und Querrichtung 144 erstreckendes zweidimensionales Bild aus den einzelnen Bildflecken 34 der Bildreihen 38' aufzubauen. Dabei werden die Ansteuerzeitpunkte t so mit der Drehung des Polygonspiegels 130 synchronisiert, daß diese vorzugsweise mit den Zeitpunkten zusammenfallen, in welchen die Strahlung 32 auf eine zwischen zwei Polygonflächen 136 liegende Kante 160 auftreffen würde.

Besonders vorteilhaft ist es dabei, wenn zu dem Zeitpunkt, zu dem die Strahlung 32 direkt auf die Kante 160 auftreffen würde, alle Halbleiteremitter kurzzeitig während der Zeit Δ tₖ abgeschaltet werden und somit keine Strahlung 32 emittieren, so lange, bis die auf die Kante 160 folgende Polygonfläche 136 wieder in einer Reflexionsstellung steht und die Strahlung 32 wiederum so reflektiert, daß die Austrittsflecken 30 der Halbleiteremitter 20 in der ersten Bildreihe 38'a liegen. Eine derartige Ansteuerung ist in Fig. 8 für den Fall der Steuerung 22 dargestellt. In diesem Fall ist der Ansteuerschalter 48 so auszubilden, daß er beim jeweiligen Ansteuerzeitpunkt t zunächst den Kondensator 46 entlädt und dann wieder mit dem korrekten, im Zwischenspeicher 50 gespeicherten Ansteuerparameter lädt.

Im Fall der Steuerung 22' ist, wie in Fig. 9 dargestellt, ein Abschalten der Halbleiteremitter 20 kurz vor dem jeweiligen Ansteuerzeitpunkt t einfach dadurch zu erreichen, daß die maximale Pulsweite Δ t um den Betrag Δ tₖ zeitlich kürzer ist als der Zeitraum zwischen aufeinanderfolgenden Ansteuerzeitpunkten t, welche vorzugsweise in konstanten Zeitabständen aufeinander folgen.

Bei dem in Fig. 6 dargestellten Ausführungsbeispiel ist vorgesehen, daß der Antrieb 134 den Polygonspiegel 130 mit im wesentlichen stabilisierter Drehzahl kontinuierlich dreht.

Alternativ dazu ist es denkbar, als Antrieb 134 einen Schrittmotor vorzusehen, der gesteuert in einzelne Drehstellungen bringbar ist und somit den Polygonspiegel 130 nicht kontinuierlich dreht, sondern in jeweils derartige Drehstellungen dreht, daß die in Reflexionsstellung stehende Polygonfläche 136 sukzessive unterschiedliche Winkelstellungen gegenüber der Strahlung 32 einnimmt, wobei jede einzelne Winkelstellung der Reflexion der Austrittsflecken 30 der Leuchtreihe 16 in eine der Bildreihen 38' entspricht und somit die Bildreihen 38' während einer definierten Zeit ausgeleuchtet werden und danach die in Reflexionsstellung stehende Polygonfläche 136 in die nächste Drehstellung "springt". In diesem Fall besteht auch die Möglichkeit, über die Kante 160 durch eine schnelle Drehung des Polygonspiegels 130 hinwegzuspringen.

Entsprechend der Ansteuerung des Schrittmotors kann dann auch der Triggerblock 52 angesteuert werden, so daß das Erfassen der Drehstellung des Polygonspiegels 130 mittels des Detektors 154 entfallen kann.

Bei den beiden vorstehend beschriebenen Ausführungsbeispielen ist pro Leuchtreihe 16 vorgesehen, daß in der Längsrichtung 18 einzelne Halbleiteremitter 20 nebeneinandersitzen und somit die Leuchtreihe 16 von einer einzigen Reihe von Halbleiteremittern 20 gebildet wird.

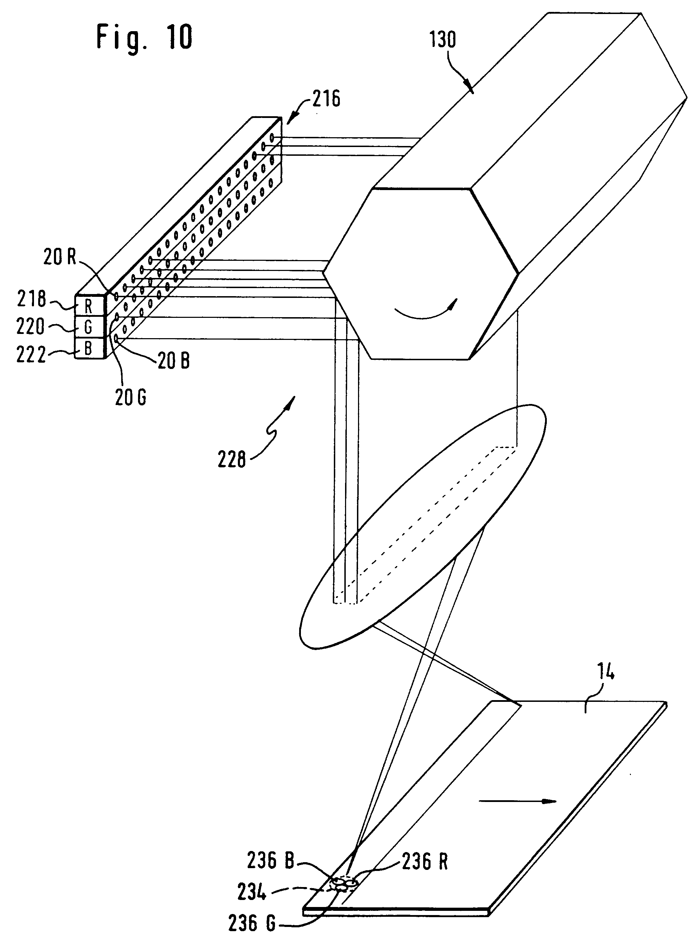

Um ein für ein menschliches Auge mehrfarbiges Bild - beispielsweise ein Fernsehbild - zu erzeugen, ist bei einem dritten Ausführungsbeispiel, schematisch dargestellt in Fig. 10, vorgesehen, daß jede Leuchtreihe 216 drei parallel zueinander verlaufende Reihen 218, 220 und 222 von Halbleiteremittern 20 aufweist, wobei die Reihe 218 aus Halbleiteremittern 20R aufgebaut ist, die rotes Licht emittieren, die Reihe 220 aus Halbleiteremittern 20G aufgebaut ist, die grünes Licht emittieren und die Reihe 222 aus Halbleiteremittern 20B aufgebaut ist, die blaues Licht emittieren.

Die Projektionsoptik 228 ist dabei so aufgebaut, daß jeweils ein Halbleiteremitter 20R, ein Halbleiteremitter 20G und ein Halbleiteremitter 20B einen Bildfleck 234 ausleuchten, wobei im einfachsten Fall vorgesehen ist, daß die von jedem der Halbleiteremitter 20R, 20G und 20B erzeugten Teilbildflecken 236B, 236G und 236R nicht deckungsgleich übereinanderliegen, sondern sich beispielsweise gar nicht oder nur teilweise überlappen. Im einfachsten Fall kann bei einer derartigen Projektionsoptik 228 auf eine Zwischenfokussierung der Strahlung 32 auf den Polygonspiegel 130 mittels der ersten Fokussierungsoptik 138 verzichtet werden.

Im übrigen ist aber die Fokussierungsoptik 228 identisch ausgebildet wie die Fokussierungsoptik 128 des zweiten Ausführungsbeispiels, so daß bezüglich Einzelheiten hierauf Bezug genommen wird.

Darüber hinaus erfolgt auch die Ansteuerung der Reihen 218, 220 und 222 der Halbleiteremitter 20R, 20G und 20B analog der im Zusammenhang mit dem ersten Ausführungsbeispiel beschriebenen Möglichkeiten, wobei allerdings für jede der Reihen 218, 220 und 222 ein Zwischenspeicher 50 und für jeden Halbleiteremitter 20 ein Stromsteuerblock 42 erforderlich ist; jedoch erfolgt die Ansteuerung derart, daß zu einem Ansteuerzeitpunkt t die Ansteuerparameter für die Halbleiteremitter 20R, 20G und 20B aller drei Reihen 218, 220 und 222 gleichzeitig aus dem Zwischenspeicher ausgelesen werden.

Um ein farbiges Bild zu erzeugen, werden die Wellenlängen der Halbleiteremitter 20R, 20G und 20B sowie die möglichen maximalen Intensitäten so gewählt, daß für das menschliche Auge in den Bildflecken 234 alle Farben, insbesondere auch weiß, durch Farbmischung erzeugbar sind. Hierzu sind vom Bildgenerator 54 für jeden Bildfleck 34 nun drei, nämlich jeweils ein Ansteuerparameter für jeden der diesen Bildfleck 234 ausleuchtenden Halbleiteremitter 20R, 20G und 20B zu erzeugen.

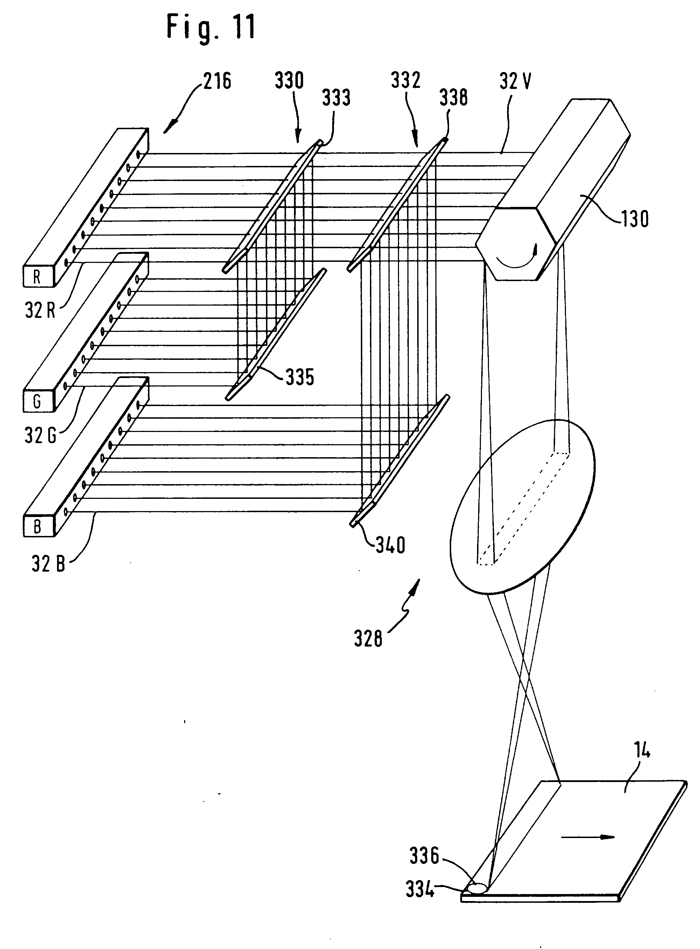

Bei einem vierten, in Fig. 11 dargestellten Ausführungsbeispiel sind ebenfalls die drei Reihen 218, 220 und 222, umfassend jeweils die Halbleiteremitter 20R, 20G und 20B, vorgesehen. Die Ansteuerung derselben erfolgt ebenfalls wie im Zusammenhang mit dem dritten Ausführungsbeispiel beschrieben.

Im Gegensatz zum dritten Ausführungsbeispiel umfaßt die Projektionsoptik 328 zwischen der Leuchtreihe 216 und dem Polygonspiegel 130 jeweils zwei Spiegelsätze 330 und 332, um die Strahlung 32R der Halbleiteremitter 20R, die Strahlung 32G der Halbleiteremitter 20G und die Strahlung 32B der Halbleiteremitter 20B miteinander zu vereinigen.

Der erste Spiegelsatz 330 umfaßt einen im Strahlengang der Strahlung 32R angeordneten dichroitischen Spiegel 333 und einen die Strahlung 32G auf den dichroitischen Spiegel 333 reflektierenden Spiegel 335. Der zweite Spiegelsatz 332 umfaßt einen im Strahlengang der Strahlung 32R angeordneten dichroitischen Spiegel 338 und einen die Strahlung 32B auf den dichroitischen Spiegel 338 reflektierenden Spiegel 340.

Durch die beiden dichroitischen Spiegel 333 und 338 wird somit die Strahlung 32R, 32G und 32B zur Strahlung 32V vereinigt, welche auf den Polygonspiegel 130 trifft und von diesem in bereits im Zusammenhang mit dem zweiten Ausführungsbeispiel beschriebener Weise auf die Bildfläche 14 reflektiert wird. Der Vorteil dieser Projektionsoptik 328 ist darin zu sehen, daß bei diesem Ausführungsbeispiel in jedem Bildfleck 334 die Teilbildflecken 336, erzeugt durch Abbildung der Austrittsflecken 30 der Halbleiteremitter 20R, 20G und 20B, im wesentlichen deckungsgleich übereinander gelegt werden können.

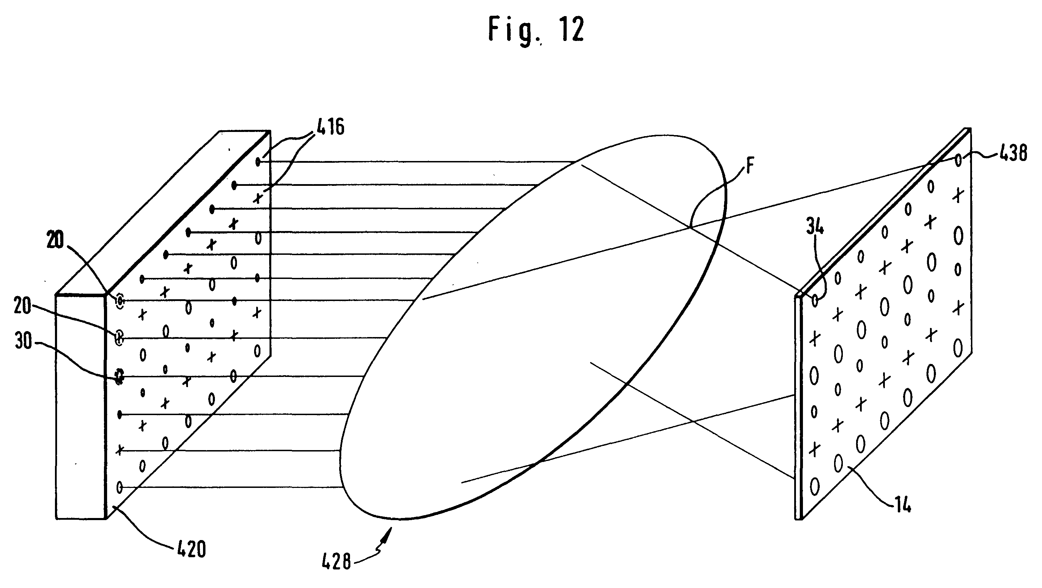

Bei einem fünften Ausführungsbeispiel, dargestellt in Fig. 12, sind mehrere Leuchtreihen 416 von Halbleiteremittern 20 in einer zweidimensionalen Matrix 420 angeordnet, und die Projektionsoptik 428 ist so aufgebaut, daß sie jeden Austrittsfleck jedes Halbleiteremitters 20 als einen Bildfleck 34 auf der Bildfläche 14 abbildet, so daß den Leuchtreihen 416 mit nebeneinanderliegenden Austrittsflecken 30 der Halbleiteremitter 20 Bildreihen 438 mit nebeneinanderliegenden Bildflecken entsprechen, wobei jeder Bildfleck 34 einem Austrittsfleck 30 des entsprechenden Halbleiteremitters 20 entspricht. Die Abbildungsoptik 428 ist dabei vorzugsweise eine Linsenoptik, die über einen Zwischenfokus F die Austrittsflecken 30 der Halbleiteremitter 20 als vergrößerte Bildflecken 34 auf der Bildfläche 14 abbildet.

Mit Halbleiteremittern 20, die Strahlung 32 derselben Wellenlänge emittieren, ist somit bei entsprechender Ansteuerung derselben ein einfarbiges zweidimensionales Bild, gebildet durch die Bildflecken 34 der Bildreihen 438 auf der Bildfläche 14 darstellbar.

Zur Bilderzeugung besteht die Möglichkeit, alle Halbleiteremitter 20 der Matrix 420 gleichzeitig strahlen zu lassen, wobei für jeden Halbleiteremitter 20 ein Steuerblock 42 oder 42' vorzusehen ist. Bei sich ändernder Bildinformation kann auch der Ansteuerparameter für den jeweiligen Stromsteuerblock 42 oder 42' geändert werden.

Es ist aber auch denkbar, die einzelnen Leuchtreihen 416 sukzessive nacheinander zu betreiben und hierbei von einer Leuchtreihe 416 zur nächstfolgenden Leuchtreihe 416 weiterzuschalten.

Darüber hinaus ist es möglich, die einzelnen Halbleiteremitter 20 der einzelnen Reihen sukzessive nacheinander anzusteuern, um analog der konventionellen Fernsehtechnik auf der Bildfläche 14 ein Bild zu erzeugen.

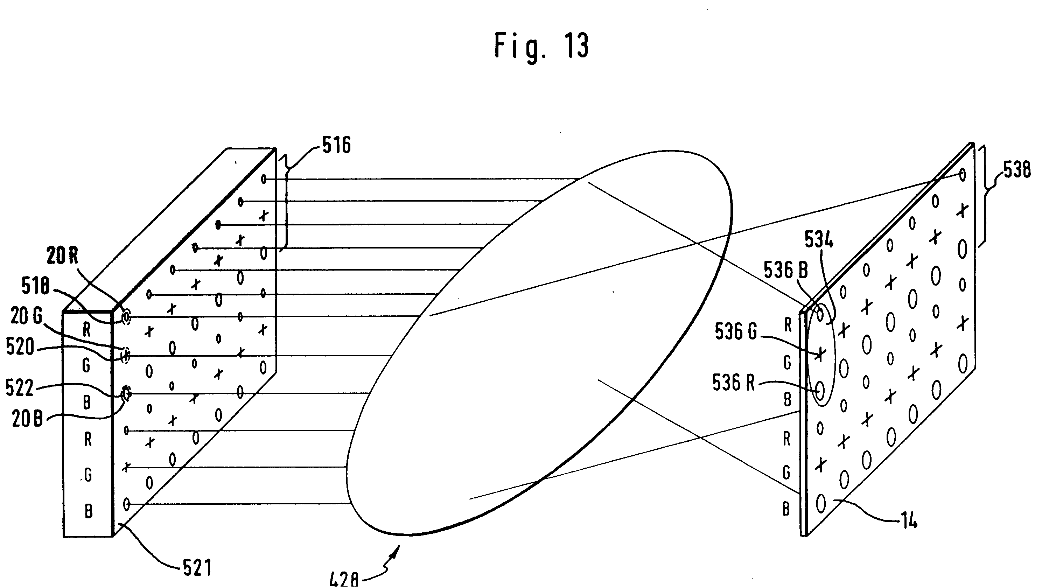

Bei einem sechsten Ausführungsbeispiel, dargestellt in Fig. 13, ist die Matrix 521 aus Halbleiteremittern so aufgebaut, daß jede Leuchtreihe 516 drei Reihen 518, 520 und 522 von Halbleiteremittern 20R, 20G und 20B aufweist, die jeweils Strahlung unterschiedlicher Wellenlänge erzeugen, beispielsweise Rot, Grün und Blau, so daß die drei Reihen 518, 520 und 522 von jeweils monochromen Halbleiteremittern 20R, 20G und 20B nach ihrer Projektion mittels der Projektionsoptik 428 auf die Bildfläche 14 Bildflecken 534 generieren, deren Teilbildflecken 536R, 536G und 536B einen für das menschliche Auge farbigen Bildeindruck aufgrund ihres geringen Abstandes vermitteln, wobei die Teilbildflecken 536R, 536G und 536B nebeneinanderliegen oder sich nur teilweise überlappen. Die Bildflecken 534 bilden somit ebenfalls Bildreihen 538.

Die Matrix 521 umfaßt nun eine Vielzahl übereinander angeordneter derartiger Leuchtreihen 516, so daß bei Einsatz derselben Projektionsoptik 428 ebenfalls eine Vielzahl von übereinander angeordneten und ein zweidimensionales Bild 12 ergebenden Bildreihen 538 entsteht.

Bei dieser Lösung sind die drei jeweils einen Bildfleck 534 ausleuchtenden Halbleiteremitter 20R, 20G und 20B jeweils gleichzeitig anzusteuern, um die gewünschte Farbmischung im Bildfleck 534 erzeugen zu können.

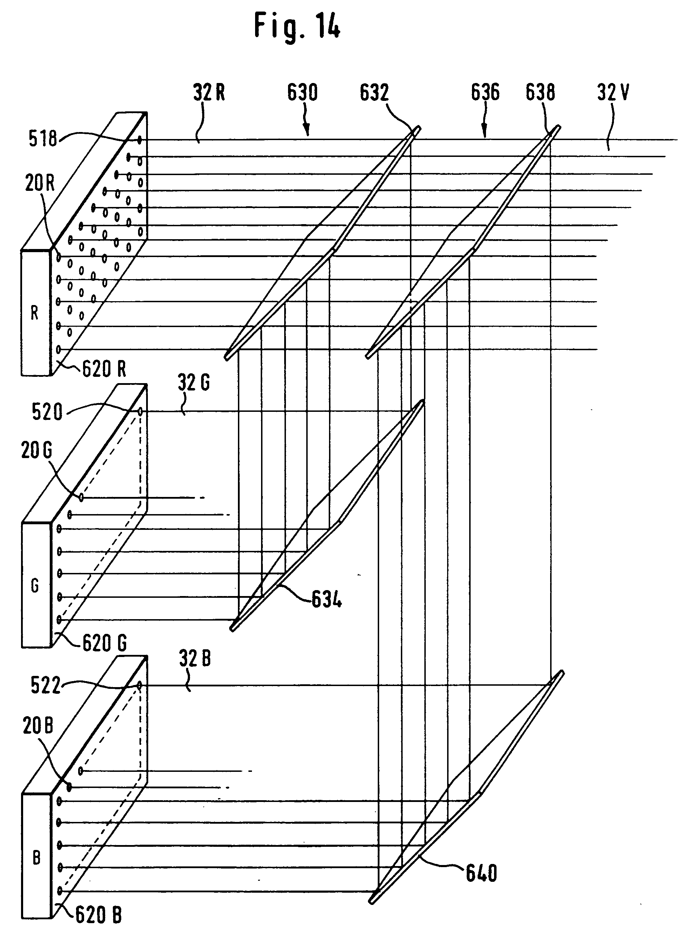

Alternativ zu dem sechsten Ausführungsbeispiel, dargestellt in Fig. 13, ist bei einem siebten Ausführungsbeispiel, dargestellt in Fig. 14, vorgesehen, die Reihen 518 von Halbleiteremittern 20R zu einer Matrix 620R zusammenzufassen, die Reihen 520 von Halbleiteremittern 20G zu einer Matrix 620G und die Reihen 522 von Halbleiteremittern 20B zu einer Matrix 620B. Die Strahlung 32R der Gesamtheit der Halbleiteremitter der Matrix 620R wird nun durch einen Spiegelsatz 630 mit der Strahlung 32G der Matrix 620G dadurch vereinigt, daß im Strahlenverlauf der Strahlung 32R ein dichroitischer Spiegel 632 angeordnet ist, auf welchen ein Spiegel 634 die Strahlung 32G der Matrix 620G reflektiert. In gleicher Weise ist ein Spiegelsatz 636 vorgesehen, welcher einen dichroitischen Spiegel 638 ebenfalls in dem Strahlengang der Strahlung 32R aufweist, auf welchen ein Reflexionsspiegel 640 die Strahlung 32B der Matrix 620B reflektiert, so daß insgesamt die Strahlung 32V alle drei Strahlungen 32R, 32G und 32B vereinigt, wobei die Spiegelsätze 630 und 636 so auszubilden sind, daß die Strahlungen 32R, 32G und 32B einander entsprechender Halbleiteremitter 20R, 20G und 20B einen Bildfleck entweder durch Überlappung oder durch nahe beieinanderliegende Teilbildflecken ausleuchten und somit einen Gesamtfarbeindruck vermitteln.

Im übrigen ist die Projektionsoptik bei dem siebten Ausführungsbeispiel in gleicher Weise ausgebildet wie beim fünften und sechsten Ausführungsbeispiel, so daß hierauf vollinhaltlich Bezug genommen werden kann.

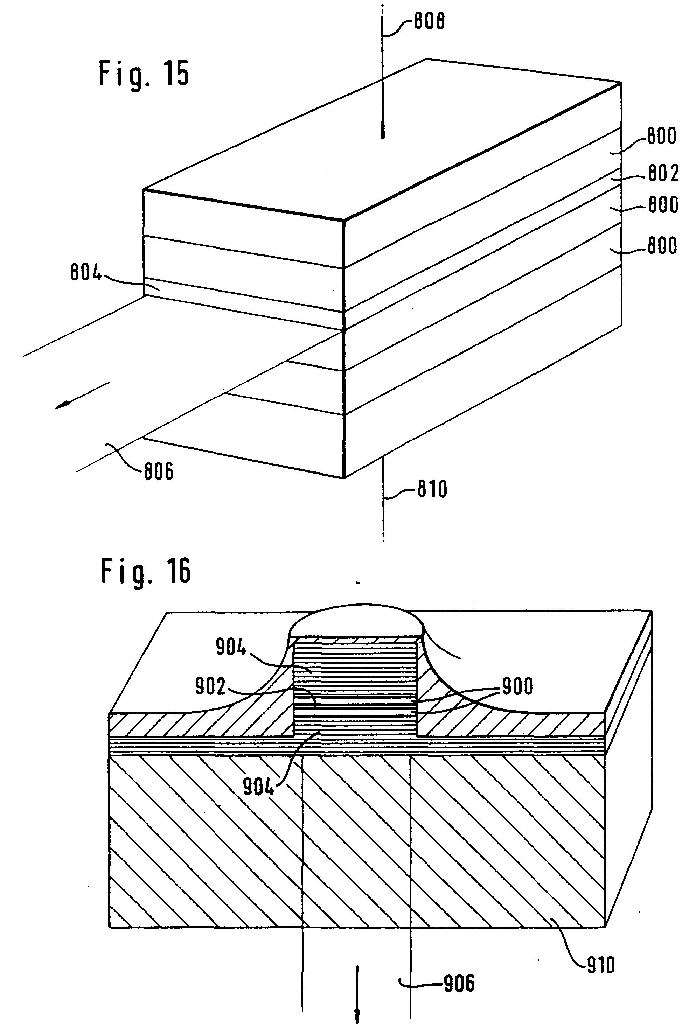

Bei allen vorstehend beschriebenen Ausführungsbeispielen der erfindungsgemäßen Vorrichtung umfassen die Halbleiteremitter als Strahlungsquellen vorzugsweise als sogenannte Kantenemitter ausgebildete Halbleiterlaser, wie in Fig. 15 schematisch dargestellt. Derartige Kantenemitter bestehen aus einer Vielzahl von Halbleiterschichten 800, zwischen denen eine laseraktive Schicht 802 angeordnet ist. Aus dieser laseraktiven Schicht tritt im Bereich eines Austrittsflecks 804 die Laserstrahlung 806 aus.

Betrieben wird ein derartiger Kantenemitter durch Stromzufuhr über zwei Stromanschlüsse 808 und 810, wobei der Strom im wesentlichen senkrecht zu den Schichten 800 und 802 fließt.

Ausführungsbeispiele derartiger Kantenemitter sind in der Zeitschrift Laser Focus World, Juli 1993, Vol. 29, No. 7, Seiten 83 bis 92 ausführlich beschrieben.

Der Vorteil dieser Kantenemitter ist darin zu sehen, daß diese in einfacher Weise nebeneinandergereiht als sogenanntes Array auf einem Substrat hergestellt werden können.

Alternativ zum Vorsehen von Kantenemittern ist es möglich, als Strahlungsquellen Halbleiterlaser in Form von sogenannten Vertikalemittern, dargestellt in Fig. 16, vorzusehen, wobei bei derartigen Vertikalemittern ebenfalls eine laseraktive Schicht 902 zwischen einer Vielzahl von Halbleiterschichten 900 vorgesehen ist und beiderseits der laseraktiven Schicht 902 zusätzliche, als Braggreflektoren dienende Schichten 904 vorgesehen sind.

Bei derartigen Vertikalemittern breitet sich die entstehende Laserstrahlung nicht wie beim Kantenemitter parallel zur aktiven Schicht 802 aus, sondern senkrecht zur aktiven Schicht 902, durchsetzt das Substrat 910 und tritt dabei vorzugsweise senkrecht zur Ebene des Substrats 910 aus.

Vertikalemitter haben den Vorteil, daß die entstehende Laserstrahlung 906 einen ungefähr kreisförmigen Querschnitt aufweist und somit in einfacher Weise eine Ankopplung an weitere optische Elemente, beispielsweise faseroptische Elemente, möglich ist.

Derartige Vertikalemitter sind beispielsweise in der Zeitschrift Optics Letters, Vol. 18, Nr. 22, Seiten 1937 ff. oder in der Zeitschrift Spektrum der Wissenschaft, Januar 1992, Seiten 76 ff beschrieben. Auf diese Beschreibungen wird vollinhaltlich Bezug genommen.

Als Lasermaterialien kommen vorzugsweise für die Erzeugung von Strahlung im sichtbaren Bereich bei unterschiedlichen Farben folgende Lasermaterialien zum Einsatz:

| | | | |
|---|---|---|---|
| AlₓGa_{y}In_{1-x-y}P | auf GaAs | für 610-690 nm | rot |
| Zn₁₋ₓMgₓS_{1-y}Se_{y} | auf GaAs | für 450-550 nm | blau, grün |
| AlₓGa_{y}In_{1-x-y}N | | für | UV - rot |

Alternativ dazu besteht die Möglichkeit, andere bisher bekannte Lasermaterialien zu verwenden und die Wellenlänge des erzeugten Lichts zu verdoppeln. Derartige Materialien wären beispielsweise

| | | |
|---|---|---|
| AlₓGa₁₋ₓAs | auf GaAs (780-880 nm) | für blau |
| InₓGa₁₋ₓAs | auf GaAs (880-1100 nm) | für blau, grün |
| In₁₋ₓGaₓAs_{y}P_{1-y} | auf InP (1100-1600 nm) | für rot. |

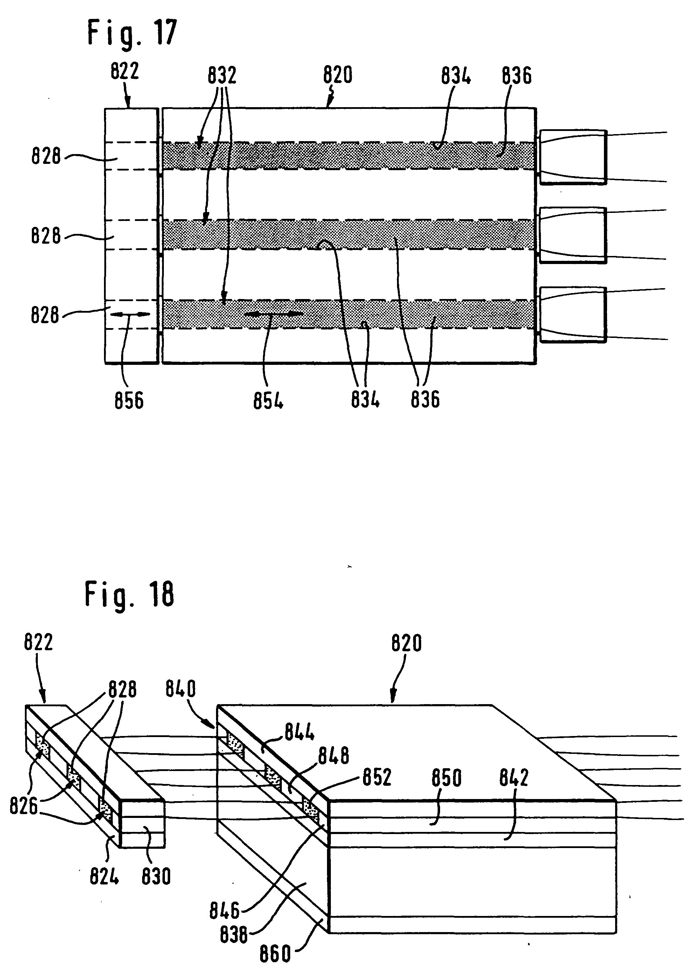

Ein Ausführungsbeispiel eines derartigen, die Wellenlänge der Strahlung der Strahlungsquelle verdoppelnden Halbleiteremitters, in Fig. 17 und 18 als Ganzes mit 820 bezeichnet, umfaßt ein Array 822 von auf einem gemeinsamen Substrat 824 angeordneten Kantenemittern 826, die durch spezielle auf dem gemeinsamen Substrat 824 angeordnete laseraktive Schichten gebildet sind und jeweils als laseraktive Schicht 802 einen streifenförmigen Bereich 828 einer auf dem gemeinsamen Substrat 824 angeordneten durchgehenden Schicht 830 aufweisen.

Jedem der als Strahlungsquelle dienenden Halbleiterlaser 826 ist jeweils ein Frequenzverdoppler 832 zugeordnet, welcher jeweils eine Wellenleiterstruktur 834 umfaßt, in welcher ein frequenzverdoppeltes Medium als Wellenleiterkern 836 angeordnet ist.

Die Wellenleiterstruktur 834 führt dabei die von dem jeweiligen Halbleiterlaser 826 erzeugte Strahlung in einem derart verengten Querschnitt, daß eine Leistungsdichte von mindestens 10⁵W/cm², vorzugsweise mindestens 10⁶W/cm², die für eine effiziente Frequenzverdopplung in dem frequenzverdoppelnden Medium erforderlich ist, erreicht wird.

Bei dem in Fig. 17 und 18 dargestellten Ausführungsbeispiel sind alle Frequenzverdoppler 832 ebenfalls auf einem gemeinsamen Substrat 838 in Form eines Arrays 840 angeordnet.

Die Wellenleiterstruktur 834 wird dabei gebildet durch eine Basisschicht 842 sowie eine Deckschicht 844, welche obere und untere Wände des Wellenleiterkanals 834 darstellen, sowie im Abstand voneinander angeordnete Streifenbereiche 846 und 848 einer Zwischenschicht 850, welche seitliche Wände des Wellenleiterkanals 834 bilden und einen Streifenbereich 852 der Zwischenschicht 850 zwischen sich einschließen, welcher das als Wellenleiterkern dienende frequenzverdoppelnde Medium 836 bildet.

Die Basisschicht 842, die Deckschicht 844 sowie die streifenförmigen Bereiche 846 und 848 der Zwischenschicht 850 weisen einen Brechungsindex auf, welcher kleiner als der Brechungsindex des streifenförmigen Bereichs 852 ist, so daß an den Grenzen zwischen dem streifenförmigen Bereich 852 und den Schichten 842 und 844 sowie den streifenförmigen Bereichen 846 und 848 eine Totalreflexion der Strahlung und somit die Führung der Strahlung in der Wellenleiterstruktur 834 erfolgt.

Vorzugsweise ist der Halbleiteremitter so aufgebaut, daß sich an das Array 822 von Halbleiterlasern 826 das Array 840 von Frequenzverdopplern 832 unmittelbar anschließt, so daß die Strahlung aus den laseraktiven Schichten 828 unmittelbar in die Wellenleiterkanäle 834 übertritt.

Zweckmäßigerweise ist dabei die Ausdehnung der Wellenleiterstrukturen 834 quer zu ihrer Längsrichtung 854 ungefähr gleich groß gewählt wie die Ausdehnung der laseraktiven Bereiche 828 quer zur Ausbreitungsrichtung 856 der Laserstrahlung.

Um in dem frequenzverdoppelnden Medium 836 eine effiziente Frequenzverdopplung zu erhalten, müssen die Grundwelle, das heißt die aus dem entsprechenden Halbleiterlaser 826 kommende Strahlung, und die frequenzverdoppelte Strahlung während des gesamten Weges durch das frequenzverdoppelnde Medium in Phase bleiben. Dies ist optimal dann erreicht, wenn mit einer unkritischen oder nicht kritischen Phasenanpassung gearbeitet wird, bei welcher der Winkel 0 oder 90° beträgt.

Dies ist nur bei wenigen Wellenlängen möglich. Eine Anpassung an die entsprechende Wellenlänge erfolgt bei dem jeweiligen Material vorzugsweise durch eine Variation der Temperatur, so daß beispielsweise das Substrat 838 auf einer Temperiervorrichtung 860 sitzt, mit welcher das gesamte Array 840 von Frequenzverdopplern 832 auf eine für die unkritische Phasenanpassung optimale Temperatur bringbar und auf dieser haltbar ist.

Die unkritische oder nichtkritische Phasenanpassung ist in dem Buch von W. Koechner "Solid State Laser Engineering" ausführlich beschrieben, so daß diesbezüglich vollinhaltlich auf diese Literaturstelle Bezug genommen wird.

Vorzugsweise ist die Temperiervorrichtung 860 mit einer Steuerung versehen, über welche eine vorgebbare Temperatur eingestellt und durch Nachregelung aufrecht erhalten werden kann.

Zweckmäßigerweise wird die Kristallrichtung in dem frequenzverdoppelnden Medium 836 durch die Ausrichtung des Substrats 838 vorgegeben, welches so orientiert wird, daß die optischen Achsen des Substrats in der gewünschten Richtung zur Längsrichtung 854 des Wellenleiterkanals 834 ausgerichtet sind. Läßt man auf dieses Substrat 838 die Schichten 842, 844 und 850 aus demselben Basismaterial, gegebenenfalls mit unterschiedlichen Dotierungen, aufwachsen, so haben diese Schichten die gleiche Ausrichtung der optischen Achsen wie das Substrat 838 und folglich ist damit auch die Lage der optischen Achsen im frequenzverdoppelnden Medium 836 vorgebbar.

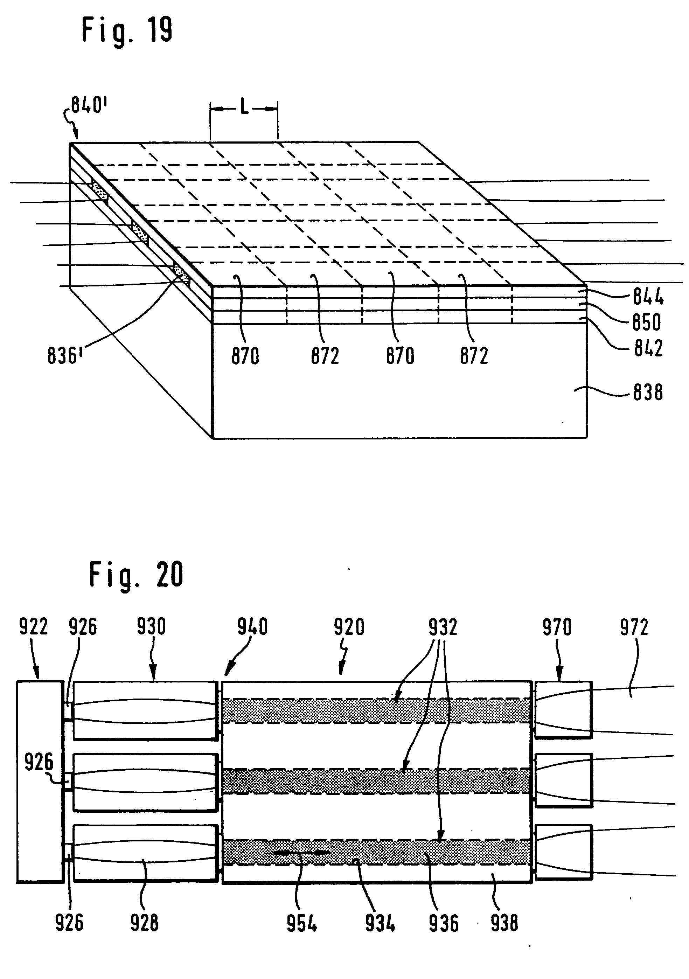

Bei einer Variante 840' des Arrays 840 von Frequenzverdopplern 832, dargestellt in Fig. 19, wird nicht mit einer unkritischen Phasenanpassung gearbeitet, sondern die Phasenanpassung wird dadurch erreicht, daß in dem frequenzverdoppelnden Medium 836' Domänen 870 und 872 aufeinanderfolgen, in welchen die nichtlinearen Koeffizienten des frequenzverdoppelnden Mediums 836 jeweils umgekehrte Vorzeichen aufweisen.

Eine Erstreckung L der Domänen 870 und 872 in der Längsrichtung 854 der Wellenleiterkanäle 834 ist dabei so abzustimmen, daß sie der Kohärenzlänge entspricht.

Mit einer derartigen Quasiphasenanpassung läßt sich außerhalb der idealen Phasenanpassung eine Phasenanpassung bei Frequenzverdopplung erreichen, die eine ausreichende Intensität der frequenzverdoppelten Strahlung gewährleistet.

Die Quasiphasenanpassung ist in der Zeitschrift Optics Letters Vol. 17, Nr. 11, Seiten 795 bis 797, in der Zeitschrift Applied Physics Letters 56 (2), Seiten 108 bis 110. oder in dem IEEE Journal of Quantum Electronics Vol. 28, Nr. 11, Seiten 2631 bis 2654, ausführlich beschrieben.

Im übrigen ist das Array 840' gleich ausgebildet wie das Array 840, so daß auf die Ausführungen hierzu vollinhaltlich Bezug genommen werden kann und für die gleichen Elemente die gleichen Bezugszeichen Verwendung finden.

Vorzugsweise kommt im Falle der unkritischen Phasenanpassung als frequenzverdoppelndes Medium ein Kristall aus Lithiumniobat für die Wellenlängen Grün und Rot zum Einsatz und für die Wellenlänge Blau ein Kristall aus Kaliumniobat.

Die Wellenleiterstruktur 834 wird dadurch erzeugt, daß das den Wellenleiterkern umgebende Material Lithiumniobat oder Kaliumniobat ist, das zusätzlich mit Magnesium oder anderen brechungsindexerniedrigenden Elementen dotiert wurde.

Bei einem zweiten Ausführungsbeispiel eines erfindungsgemäßen Halbleiteremitters, dargestellt in Fig. 20 und als Ganzes mit 920 bezeichnet, findet ein Array 922 von als Vertikalemitter ausgebildeten Halbleiterlasern 926 Verwendung. Die Strahlung 928 dieser Halbleiteremitter wird durch fokussierende Elemente 930 auf Frequenzverdoppler 932 fokussiert, die ebenfalls in einem Array 940 auf einem gemeinsamen Substrat angeordnet und in gleicher Weise ausgebildet und aufgebaut sind wie das Array 840, so daß auf die Ausführungen hierzu vollinhaltlich Bezug genommen werden kann. Die fokussierende Optik 930 ist dabei nicht als Linsenoptik ausgebildet, sondern als Gradientenindex-Linsen, welche als Block zwischen den jeweiligen Halbleiterlasern 926 und den entsprechenden Frequenzverdopplern 932 eingesetzt sind und aufgrund des Gradientenindex die Strahlung 928 auf die Wellenleiterkanäle 934 fokussieren.

Darüber hinaus sind vorzugsweise endseitig der Frequenzverdoppler 932 Aufweitungsoptiken 970 angeordnet, welche ebenfalls Gradientenindex-Linsen sind, welche ein im wesentlichen paralleles Strahlenbündel 972 erzeugen.

## Patentansprüche

1. Vorrichtung zur Erzeugung eines für das menschliche Auge sichtbaren Bildes in einer Bildfläche (14) umfassend
eine Leuchtreihe (16), welche eine Vielzahl von Halbleiteremittern (20) aufweist, von denen jeder Strahlung (32R, 32G, 32B) mit einer von drei verschiedenen Wellenlängen (R, G, B) erzeugt, mit denen durch Farbmischung weißes Licht erzeugbar ist,
eine Projektionsoptik (228, 328, 428), welche die Austrittsflecken (30) der Halbleiteremitter (20) abbildet,
**dadurch gekennzeichnet, daß** als Halbleiteremitter Halbleiterlases verwendet werden, daß die Projektionsoptik (228, 328, 428) Bildflecken (234, 334, 534) in der für das menschliche Auge sichtbaren Bildfläche (14) ausleuchtet,
daß jeder der Bildflecken (234, 334, 534) drei nicht kongruente Teilbildflecken (236R, 236G, 236B; 336; 536R, 536G, 536B) umfaßt, von denen jeder durch Strahlung (32R, 32G, 32B) mit einer von drei unterschiedlichen Wellenlängen (R, G, B) so ausleuchtbar ist, daß in dem Bildfleck (234, 334, 534) für das menschliche Auge der Farbeindruck von Mischfarben erzeugbar ist
und daß die Projektionsoptik (228, 328, 428) jedem der drei Teilbildflecken (236R, 236G, 236B; 336; 536R, 536G, 536B) einen von jeweils drei Strahlung (32R, 32G, 32B) mit den drei verschiedenen Wellenlängen (R, G, B) erzeugenden Halbleiteremittern (20R, 20G, 20B) zuordnet.

2. Vorrichtung nach einem der voranstehenden Ansprüche, **dadurch gekennzeichnet, daß** die Vielzahl der Halbleiteremitter (20) so groß ist, daß zu einem Zeitpunkt jedem Bildfleck (34) der Bildreihe (38) ein Austrittsfleck (30) eines Halbleiteremitters (20) ausschließlich zugeordnet ist.

3. Vorrichtung nach einem der voranstehenden Ansprüche, **dadurch gekennzeichnet, daß** die Halbleiteremitter (20) die Strahlung (32) im Zeitraum zwischen zwei aufeinanderfolgenden Ansteuerzeitpunkten (t₁, t₂ ...) emittieren.

4. Vorrichtung nach Anspruch 3, **dadurch gekennzeichnet, daß** die Ansteuerzeitpunkte (t₁, t₂,...)in konstanten Zeitabständen aufeinanderfolgen.

5. Vorrichtung nach Anspruch 3 oder 4, **dadurch gekennzeichnet, daß** die Halbleiteremitter (20) die Strahlung (32) mit variabel einstellbarer Intensität emittieren.

6. Vorrichtung nach Anspruch 5, **dadurch gekennzeichnet, daß** die Halbleiteremitter (20) zwischen zwei Ansteuerzeitpunkten (t₁, t₂,...) die Strahlung (32) mit der eingestellten Intensität im wesentlichen unverändert emittieren.

7. Vorrichtung nach Anspruch 5 oder 6, **dadurch gekennzeichnet, daß** die Einstellung der Intensität der Strahlung (32) jedes Halbleiteremitters (20) zu jedem Ansteuerzeitpunkt (t₁, t₂,...) erfolgt.

8. Vorrichtung nach einem der Ansprüche 1 bis 4, **dadurch gekennzeichnet, daß** die Halbleiteremitter (20) zwischen den Ansteuerzeitpunkten (t₁,t₂,...) entweder Strahlung (32) mit maximaler Intensität, aber variabel einstellbarer Zeitdauer (Δ t₁, Δ t₂,...) oder keine Strahlung emittieren.

9. Vorrichtung nach Anspruch 8, **dadurch gekennzeichnet, daß** die Einstellung einer mittleren, von einem Beobachter wahrgenommenen Intensität durch Modulation der Zeitdauer (Δ t₁, Δ t₂,...) der Emission der Strahlung (32) erfolgt.

10. Vorrichtung nach Anspruch 8 oder 9, **dadurch gekennzeichnet, daß** die Einstellung der Zeitdauer (Δ t₁, Δ t₂,...) der Emission der Strahlung (32) zu jedem Ansteuerzeitpunkt (t₁, t₂,...) erfolgt.

11. Vorrichtung nach einem der voranstehenden Ansprüche, **dadurch gekennzeichnet, daß** die-drei, jeweils einen Bildfleck (34) ausleuchtenden Halbleiteremitter (20R, 20G, 20B) gleichzeitig ansteuerbar sind.

12. Vorrichtung nach einem der voranstehenden Ansprüche, **dadurch gekennzeichnet, daß** die Leuchtreihe (16) mindestens eine Reihe von Halbleiteremittern (20) aufweist, die Strahlung derselben Wellenlänge emittieren.

13. Vorrichtung nach Anspruch 12, **dadurch gekennzeichnet, daß** zur Ausleuchtung der Bildflecken (34) einer Bildreihe (38) die entsprechende Leuchtreihe (16) drei parallel zueinander verlaufende Reihen (218, 220, 222; 518, 520, 522) von Halbleiteremittern (20R, 20G, 20B) umfaßt, wobei die Halbleiteremitter (20R, 20G, 20B) jeder Reihe Strahlung im wesentlichen derselben Wellenlänge emittieren.

14. Vorrichtung nach einem der voranstehenden Ansprüche, **dadurch gekennzeichnet, daß** von den Halbleiteremittern (20) einer Leuchtreihe (16) mindestens diejenigen zu demselben Ansteuerzeitpunkt ansteuerbar sind, die einem Zehntel der Bildflecken (34) einer Bildreihe (38) zugeordnet sind.

15. Vorrichtung nach Anspruch 14, **dadurch gekennzeichnet, daß** die allen Bildflecken (34) einer Bildreihe (38) zugeordneten Halbleiteremitter (20) einer Leuchtreihe (16) gleichzeitig ansteuerbar sind.

16. Vorrichtung nach einem der voranstehenden Ansprüche, **dadurch gekennzeichnet, daß** zur-gleichzeitigen Ansteuerung mehrerer Halbleiteremitter (20) ein Zwischenspeicher (50) vorgesehen ist, aus welchem die Ansteuerparameter zur gleichzeitigen Ansteuerung der mehreren Halbleiteremitter (20) parallel auslesbar sind.

17. Vorrichtung nach Anspruch 16, **dadurch gekennzeichnet, daß** der Zwischenspeicher (50) zwischen den Ansteuerzeitpunkten (t₁, t₂, ...) die Ansteuerparameter für die Halbleiteremitter (20) aufnimmt.

18. Vorrichtung nach Anspruch 17, **dadurch gekennzeichnet, daß** die Ansteuerparameter in den Zwischenspeicher (50) seriell einlesbar sind.

19. Vorrichtung nach einem der Ansprüche 16 bis 18, **dadurch gekennzeichnet, daß** die Ansteuerparameter von einem Bildgenerator (34) erzeugbar sind.

20. Vorrichtung nach Anspruch 19, **dadurch gekennzeichnet, daß** der Bildgenerator (54) die Ansteuerparameter seriell generiert.

21. Vorrichtung nach einem der voranstehenden Ansprüche, **dadurch gekennzeichnet, daß** jedem Halbleiteremitter (20) eine Ansteuerung (42, 60) zugeordnet ist, welche den Ansteuerparameter von einem Ansteuerzeitpunkt (t₁) bis zum nächsten Ansteuerzeitpunkt (t₂) speichert.

22. Vorrichtung nach einem der voranstehenden Ansprüche, **dadurch gekennzeichnet, daß** die-Projektionsoptik (28, 128, 228) eine Leuchtreihe (16) sukzessive auf mehrere Bildreihen (38a, ... 38b) abbildet.

23. Vorrichtung nach Anspruch 22, **dadurch gekennzeichnet, daß** die Projektionsoptik (28, 128, 228) ein strahlumlenkendes Element (130) umfaßt, welches die Leuchtreihe (16) in aufeinanderfolgende Bildreihen (38) abbildet.

24. Vorrichtung nach Anspruch 23, **dadurch gekennzeichnet, daß** das strahlumlenkende Element ein bewegbares Reflexionselement (130) ist.

25. Vorrichtung nach Anspruch 24, **dadurch gekennzeichnet, daß** das Reflexionselement (130) in definierte Winkelpositionen bewegbar ist, die die Leuchtreihe (16) in jeweils eine der Bildreihen (38) abbilden.

26. Vorrichtung nach einem der Ansprüche 23 bis 25, **dadurch gekennzeichnet, daß** das strahlumlenkende Element durch einen rotierenden Polygonspiegel (130) gebildet ist.

27. Vorrichtung nach Anspruch 26, **dadurch gekennzeichnet, daß** der Polygonspiegel (130) mit konstanter Drehzahl rotiert.

28. Vorrichtung nach Anspruch 27, **dadurch gekennzeichnet, daß** der Polygonspiegel (130) mit jeder Polygonfläche (136) die Zahl der Bildreihen (38) durch Drehung in einem bestimmten Winkelbereich durchläuft und dann zur nächsten Polygonfläche (136) übergeht.

29. Vorrichtung nach einem der Ansprüche 23 bis 28, **dadurch gekennzeichnet, daß** die Projektionsoptik (28) die Strahlung der Halbleiteremitter (20) der Leuchtreihe (16) im wesentlichen auf das strahlumlenkende Element (130) fokussiert.

30. Vorrichtung nach einem der Ansprüche 1 bis 21, **dadurch gekennzeichnet, daß** jeder Bildreihe (38) eine Leuchtreihe (16) zugeordnet ist.

31. Vorrichtung nach Anspruch 30, **dadurch gekennzeichnet, daß** die Projektionsoptik (428, 628) die Vielzahl von Leuchtreihen (16) in die Vielzahl von Bildreihen (38) abbildet.

32. Vorrichtung nach einem der voranstehenden Ansprüche, **dadurch gekennzeichnet, daß** die Projektionsoptik (28, 128, 228, 328, 428, 628) geringe Abstände voneinander aufweisende Bildflecken (34) erzeugt.

33. Vorrichtung nach Anspruch 32, **dadurch gekennzeichnet, daß** die Bildflecken (34) im wesentlichen aneinander angrenzen.

34. Vorrichtung nach einem der voranstehenden Ansprüche, **dadurch gekennzeichnet, daß** die Projektionsoptik (228, 328) die Strahlung (32R, 32G, 32B) der drei mit unterschiedlicher Wellenlänge strahlenden Halbleiteremitter (20R, 20G, 20B) zu einem Strahlenbündel (32V) vereinigt.

35. Vorrichtung nach einem der vorstehenden Ansprüche, **dadurch gekennzeichnet, daß** jeder Halbleiteremitter (820, 920) eine Halbleiterstrahlungsquelle (826, 926) und einen Frequenzverdoppler (832, 932) für die von der Halbleiterstrahlungsquelle emittierte Strahlung umfaßt.

36. Vorrichtung nach Anspruch 35, **dadurch gekennzeichnet, daß** der Frequenzverdoppler (832, 932) eine die Strahlung jeder Strahlungsquelle (826, 926) mit einer Leistungsdichte von mindestens 10⁵W/cm² komprimiert führende Wellenleiterstruktur (834, 934) und ein in der Wellenleiterstruktur (834, 934) angeordnetes frequenzverdoppelndes Medium (836, 936) umfaßt.

37. Vorrichtung nach Anspruch 35 oder 36, **dadurch gekennzeichnet, daß** die Frequenzverdoppler (832) sich unmittelbar an die Strahlungsquellen (826) anschließen.

38. Vorrichtung nach Anspruch 35 oder 36, **dadurch gekennzeichnet, daß** zwischen jeder Strahlungsquelle (926) und jedem Frequenzverdoppler (932) eine die Strahlung in die Wellenleiterstruktur (934) fokussierende Optik (930) angeordnet ist.

39. Vorrichtung nach einem der Ansprüche 35 bis 38, **dadurch gekennzeichnet, daß** die Strahlungsquellen (826, 926) einer Leuchtreihe (16) in einer Reihe angeordnet sind und die Frequenzverdoppler (832, 932) der Leuchtreihe (16) ausgangsseitig der Strahlungsquellen (826, 926) in ebenfalls einer Reihe angeordnet sind.

40. Vorrichtung nach einem der Ansprüche 35 bis 39, **dadurch gekennzeichnet, daß** mehrere der-Strahlungsquellen (826) auf einem gemeinsamen Substrat (834) angeordnet sind.

41. Vorrichtung nach einem der Ansprüche 35 bis 40, **dadurch gekennzeichnet, daß** mehrere der Frequenzverdoppler (832, 932) auf einem gemeinsamen Substrat (838) angeordnet sind.

42. Vorrichtung nach einem der Ansprüche 35 bis 41, **dadurch gekennzeichnet, daß** jede Wellenleiterstruktur (834, 934) jedes Frequenzverdopplers (832, 932) ein "single-mode"-Wellenleiter ist.

43. Vorrichtung nach einem der Ansprüche 35 bis 42, **dadurch gekennzeichnet, daß** jede Wellenleiterstruktur (834, 934) durch ein das den Wellenleiterkern bildende frequenzverdoppelnde Medium (836, 936) umgebendes und einen niedrigeren Brechungsindex als der Wellenleiterkern aufweisendes Wandmaterial gebildet ist.

44. Vorrichtung nach Anspruch 43, **dadurch gekennzeichnet, daß** das Wandmaterial auf demselben Material wie das frequenzverdoppelnde Medium (836, 936) basiert und aufgrund unterschiedlicher Dotierung einen niedrigeren Brechungsindex als dieses aufweist.

45. Vorrichtung nach Anspruch 43 oder 44, **dadurch gekennzeichnet, daß** die Wellenleiterstruktur (834, 934) durch Dotierung von das Wandmaterial bildenden Bereichen in einem mit dem frequenzverdoppelnden Mediums identischen Material gebildet ist.

46. Vorrichtung nach einem der Ansprüche 35 bis 45, **dadurch gekennzeichnet, daß** die Wellenleiterstruktur (834, 934) durch auf einem Substrat (838, 938) aufgetragene und das Wandmaterial umfassende Schichten (842, 844, 850) gebildet ist.

47. Vorrichtung nach einem der Ansprüche 35 bis 46, **dadurch gekennzeichnet, daß** das frequenzverdoppelnde Medium (836, 936) durch eine auf einem Substrat (838, 938) aufgetragene Schicht (850) gebildet ist.

48. Vorrichtung nach Anspruch 47, **dadurch gekennzeichnet, daß** eine definierte Ausrichtung von optischen Achsen des frequenzverdoppelnden Mediums (836, 936) durch Ausrichtung des Substrats (838, 938) vorgegeben ist.

49. Vorrichtung nach einem der Ansprüche 36 bis 48, **dadurch gekennzeichnet, daß** das frequenzverdoppelnde Medium (836, 936) so ausgebildet und hinsichtlich seiner optischen Achsen zum Wellenleiterkanal so ausgerichtet ist, daß eine unkritische Phasenanpassung zwischen der Strahlung und der frequenzverdoppelten Strahlung in Längsrichtung (834, 954) der Wellenleiterstruktur (834, 934) erfolgt.

50. Vorrichtung nach Anspruch 49, **dadurch gekennzeichnet, daß** das frequenzverdoppelnde Medium (836, 936) auf eine definierte Temperatur bringbar ist.

51. Vorrichtung nach einem der Ansprüche 36 bis 48, **dadurch gekennzeichnet, daß** das frequenzverdoppelnde Medium (836') so ausgebildet und ausgerichtet ist, daß in Längsrichtung (854) der Wellenleiterstruktur (834) eine Quasiphasenanpassung erfolgt.

## Claims

1. Apparatus for the generation in an image plane (14) of an image which is visible to the human eye, including:
a row (16) of light sources comprising a plurality of semiconductor emitters (20), each of which generates radiation (32R, 32G, 32B) with one of three different wavelengths (R, G, B), from which white light can be produced by colour mixing;
an optical projection system (228, 328, 428), which images the output spots (30) of the semiconductor emitters (20);
**characterised in that** as semiconductor emitters there are used semiconductor lasers;
**in that** the optical projection system (228, 328, 428) projects imaging spots (234, 334, 534) in the image plane (14) visible to the human eye;
**in that** each of the imaging spots (234, 334, 534) includes three non-congruent partial imaging spots (236R, 236G, 236B; 336; 536R, 536G, 536B), each of which can be projected by means of radiation (32R, 32G, 32B) with one of three different wavelengths (R, G, B) so that for the human eye the colour impression of mixed colours can be produced in the imaging spot (234, 334, 534), and **in that** the optical projection system (228, 328, 428) associates, with each of the three partial imaging spots (236R, 236G, 236B; 336; 536R, 536G, 536B), a semiconductor emitter (20R, 20G, 20B) generating radiation (32R, 32G, 32B) with in each case one of the three different wavelengths (R, G, B).

2. Apparatus in accordance with any of the preceding claims, **characterised in that** the number of semiconductor emitters (20) is so large that, at any one point in time, one output spot (30) of a semiconductor emitter (20) is exclusively associated with each imaging spot (34) of the row of images (38).

3. Apparatus in accordance with any of the preceding claims, **characterised in that** the semiconductor emitters (20) emit the radiation (32) in the time period between two successive control time points (t₁, t₂ ...).

4. Apparatus in accordance with Claim 3, **characterised in that** the control time points (t₁, t₂ ...) succeed one another at constant time intervals.

5. Apparatus in accordance with Claim 3 or 4, **characterised in that** the semiconductor emitters (20) emit the radiation (32) with a variably adjustable intensity.

6. Apparatus in accordance with Claim 5, **characterised in that** the semiconductor emitters (20) emit the radiation (32) with the set intensity substantially unaltered between two control time points (t₁, t₂ ...).

7. Apparatus in accordance with Claim 5 or 6, **characterised in that** the setting of the intensity of the radiation (32) from each semiconductor emitter (20) occurs at each control time point (t₁, t₂ ...).

8. Apparatus in accordance with any of the Claims 1 to 4, **characterised in that** the semiconductor emitters (20) either emit the radiation (32) with maximum intensity but with a variably adjustable duration (Δ t₁, Δ t₂, ...) between the control time points (t₁, t₂ ...) or do not emit any radiation.

9. Apparatus in accordance with Claim 8, **characterised in that** the setting of an average intensity, which is perceptible by an observer, is effected by modulating the duration (Δ t₁, Δ t₂, ...) of the emission of the radiation (32).

10. Apparatus in accordance with Claim 8 or 9, **characterised in that** the setting of the duration (Δ t₁, Δ t₂, ...) of the emission of the radiation (32) occurs at each control time point (t₁, t₂ ...).

11. Apparatus in accordance with any of the preceding claims, **characterised in that** the three semiconductor emitters (20R, 20G, 20B), each illuminating a respective imaging spot (34) can be operated simultaneously.

12. Apparatus in accordance with any of the preceding Claims, **characterised in that**, the row of light sources (16) comprises at least one row of semiconductor emitters (20) which emit radiation of the same wavelength.

13. Apparatus in accordance with Claim 12, **characterised in that** the row of light sources (16) comprises three rows (218, 220, 222; 518, 520, 522) of semiconductor emitters (20R, 20G, 20B) which run in parallel with one another for the illumination of the imaging spots (34) of a corresponding row of images (38), wherein the semiconductor emitters (20R, 20G, 20B) of each row emit radiation of substantially the same wavelength.

14. Apparatus in accordance with any of the preceding Claims, **characterised in that**, of the semiconductor emitters (20) of one row of light sources (16), at least those, which correspond to one tenth of the imaging spots (34) of a row of images (38), can be controlled at the same control time point.

15. Apparatus in accordance with Claim 16, **characterised in that**, the semiconductor emitters (20) of a row of light sources (16) which are associated with all of the imaging spots (34) of a row of images (38) can be controlled at the same time.

16. Apparatus in accordance with any of the preceding Claims, **characterised in that** a buffer store (50), from which the control parameters can be read-out in parallel for the simultaneous control of a plurality of semiconductor emitters (20), is provided for the simultaneous control of the plurality of semiconductor emitters (20).

17. Apparatus in accordance with Claim 16, **characterised in that**, the buffer store (50) records the control parameters for the semiconductor emitters (20) between the control time points (t₁, t₂ ... ).

18. Apparatus in accordance with Claim 17, **characterised in that**, the control parameters can be serially read-in to the buffer store (50).

19. Apparatus in accordance with any of the Claims 16 to 18, **characterised in that** the control parameters can be produced by an image generator (34).

20. Apparatus in accordance with Claim 19, **characterised in that**, the image generator (54) generates the control parameters in serial fashion.

21. Apparatus in accordance with any of the preceding Claims, **characterised in that** a control means (42, 60), which stores the control parameter from one control time point (t₁) to the next control time point (t₂), is associated with each of the semiconductor emitters (20).

22. Apparatus in accordance with any of the preceding Claims, **characterised in that** the optical projection system (28, 128, 228) successively forms an image of a row of light sources (16) as a plurality of rows of images (38a, ... 38b).

23. Apparatus in accordance with Claim 22, **characterised in that** the optical projection system (28, 128, 228) comprises a beam deflecting element (130) which forms the image of a row of light sources (16) as successive rows of images (38).

24. Apparatus in accordance with Claim 23, **characterised in that** the beam deflecting element is a movable reflecting element (130).

25. Apparatus in accordance with Claim 24, **characterised in that** the reflecting element can be moved into defined angular positions which respectively form the image of the row of light sources (16) in a respective one of the rows of images (38).

26. Apparatus in accordance with any of the Claims 23 to 25, **characterised in that** the beam deflecting element is formed by a rotating polygonal reflector (130).

27. Apparatus in accordance with Claim 26, **characterised in that** the polygonal reflector (130) rotates at a constant rotational speed.

28. Apparatus in accordance with Claim 27, **characterised in that**, for each surface (136) of the polygon, the polygonal reflector (130) traverses across the number of rows of images (38) by rotation through a particular angular range and then changes over to the next surface (136) of the polygon.

29. Apparatus in accordance with any of the Claims 23 to 28, **characterised in that** the optical projection system (28) focuses the radiation from the semiconductor emitters (20) of the row of light sources (16) substantially onto the beam deflecting element (130).

30. Apparatus in accordance with any of the Claims 1 to 21, **characterised in that** a row of light sources (16) is associated with each row of images (38).

31. Apparatus in accordance with Claim 30, **characterised in that** the optical projection system (428, 628) forms the image of the plurality of rows of light sources (16) as a plurality of rows of images (38).

32. Apparatus in accordance with any of the preceding Claims, **characterised in that** the optical projection system (28, 128, 228, 328, 428, 628) produces imaging spots (34) which have a very small separation from one another.

33. Apparatus in accordance with Claim 32, **characterised in that** the imaging spots (34) substantially border onto one another.

34. Apparatus in accordance with any of the preceding Claims, **characterised in that** the optical projection system (228, 328) combines the radiation (32R, 32G, 32B) from the three semiconductor emitters (20R, 20G, 20B), which radiate at different wavelengths, into one beam (32V).

35. Apparatus in accordance with any of the preceding Claims, **characterised in that** each semiconductor emitter (820, 920) comprises a semiconductor radiation source (826, 926) and a frequency doubler (832, 932) for the radiation emitted by the semiconductor radiation source.

36. Apparatus in accordance with Claim 35, **characterised in that**, the frequency doubler (832, 932) comprises a waveguide structure (834, 934) which guides the radiation from each radiation source (826, 926) in a compressed manner with a power density of at least 10⁵W/cm² and a frequency doubling medium (836, 936) arranged in the waveguide structure (834, 934)

37. Apparatus in accordance with Claim 35 or 36, **characterised in that** the frequency doublers (832) are directly adjacent to the radiation sources (826).

38. Apparatus in accordance with Claim 35 or 36, **characterised in that** an optical means (930), which focuses the radiation into the waveguide structure (934), is arranged between each radiation source (926) and each frequency doubler (932).

39. Apparatus in accordance with any of the Claims 35 to 38, **characterised in that** the radiation sources (826, 926) of a row of light sources (16) are arranged in a row and the frequency doublers (832, 932) of the row of light sources (16) are arranged, likewise in a row, at the output sides of the radiation sources (826, 926).

40. Apparatus in accordance with any of the Claims 35 to 39, **characterised in that** a plurality of the radiation sources (826) are arranged on a common substrate (834).

41. Apparatus in accordance with any of the Claims 35 to 40, **characterised in that** a plurality of the frequency doublers (832, 932) are arranged on a common substrate (838).

42. Apparatus in accordance with any of the Claims 35 to 41, **characterised in that** each waveguide structure (834, 934) of each frequency doubler (832, 932) is a "single mode" waveguide.

43. Apparatus in accordance with any of the Claims 35 to 42, **characterised in that** each waveguide structure (834, 934) is formed by a wall material which surrounds the frequency doubling medium (836, 936) forming the core of the waveguide and which has a lower refractive index than the core of the waveguide.

44. Apparatus in accordance with Claim 43, **characterised in that** the wall material is based on the same material as the frequency doubling medium (836, 936) and has a lower refractive index than this due to a different doping.

45. Apparatus in accordance with Claim 43 or 44, **characterised in that** the waveguide structure (834, 934) is formed by doping those regions that form the wall material, in a material which is identical to the frequency doubling medium.

46. Apparatus in accordance with any of the Claims 35 to 45, **characterised in that** the waveguide structure (834, 934) is formed by layers (842, 844, 850) which are applied to a substrate (838, 938) and which comprise the wall material.

47. Apparatus in accordance with any of the Claims 35 to 46, **characterised in that** the frequency doubling medium (836, 936) is formed by a layer (850) which is applied to a substrate (838, 938).

48. Apparatus in accordance with Claim 47, **characterised in that** a defined alignment of the optical axes of the frequency doubling medium (836, 936) is predetermined by the alignment of the substrate (838, 938).

49. Apparatus in accordance with any of the Claims 36 to 48, **characterised in that** the frequency doubling medium (836, 936) is so formed, and, as regards its optical axes, is so aligned relative to the channel of the waveguide that there results a non-critical phase matching between the radiation and the frequency doubled radiation in the longitudinal direction (834, 954) of the waveguide structure (834, 934).

50. Apparatus in accordance with Claim 49, **characterised in that** the frequency doubling medium (836, 936) can be brought up to a defined temperature.

51. Apparatus in accordance with any of the Claims 36 to 48, **characterised in that** the frequency doubling medium (836') is so formed, and is so aligned, that there results a quasi-phase-matching in the longitudinal direction (854) of the waveguide structure (834).

## Revendications

1. Dispositif pour produire une image visible pour l'oeil humain, sur une surface image (14), comprenant
une rampe lumineuse (16), qui possède une multiplicité d'émetteurs à semiconducteurs (20), dont chacun produit un rayonnement (32R, 32G, 32B) possédant l'une de trois longueurs d'onde différentes (R, G, B), avec lesquelles une lumière blanche peut être produite par mélange des couleurs,
un système optique de projection (228, 328, 428), qui forme l'image des spots de sortie (30) des émetteurs à semiconducteurs (20),
**caractérisé en ce qu'**on utilise des lasers à semiconducteurs comme émetteurs à semiconducteurs,
que le système optique de projection (228, 328, 428) éclaire des zones d'image (234, 334, 534) dans la surface image (14) visible pour l'oeil humain,
que chacune des zones d'image (234, 334, 534) comprend trois zones d'image partielles non congruentes (236R, 236G, 236B; 336; 536R, 536G, 536B), dont il est possible d'éclairer chacune par un rayonnement (32R, 32G, 32B) avec l'une de trois longueurs d'onde différentes (R, G, B) au point de pouvoir produire pour l'oeil humain l'impression de couleurs mixtes dans la zone d'image (234, 334, 534), et
que le système optique de projection (228, 328, 428) associe à chacun des trois zones d'image partielles (236R, 236G, 236B; 336; 536R, 536G, 536B) l'un de respectivement trois émetteurs à semi-conducteurs (20R, 20G, 20B) produisant des rayonnements (32R, 32G, 32B) possédant les trois longueurs d'onde différentes (R, G, B).

2. Dispositif selon l'une des revendications précédentes, **caractérisé en ce que** la multiplicité des émetteurs à semiconducteurs (20) est si grande qu'un spot de sortie (30) d'un émetteur à semiconducteurs (20) est associé exclusivement, à un instant, à une zone d'image (34) de la série d'images (38).

3. Dispositif selon l'une des revendications précédentes, **caractérisé en ce que** les émetteurs à semiconducteurs (20) émettent le rayonnement (32) dans le temps entre deux instants successifs de commande (t₁, t₂, ...).

4. Dispositif selon la revendication 3, **caractérisé en ce que** les instants de commande (t₁, t₂, ...) se succèdent à des intervalles constants.

5. Dispositif selon la revendication 3 ou 4, **caractérisé en ce que** les émetteurs à semiconducteurs (20) émettent le rayonnement (32) avec une intensité réglable de façon variable.

6. Dispositif selon la revendication 5, **caractérisé en ce que** les émetteurs à semiconducteurs (20) émettent le rayonnement (32) avec l'intensité réglée d'une manière essentiellement constante entre deux instants de commande (t₁, t₂, ...).

7. Dispositif selon la revendication 5 ou 6, **caractérisé en ce que** le réglage de l'intensité de rayonnement (32) de chaque émetteur à semiconducteurs (20) s'effectue à chaque instant de commande (t₁, t₂, ...).

8. Dispositif selon l'une des revendications 1 à 4, **caractérisé en ce que** les émetteurs à semiconducteurs (20) émettent, entre les instants de commande (t₁, t₂, ...), soit un rayonnement (32) ayant l'intensité maximale mais avec une durée réglable d'une manière variable (Δt₁, Δt₂, ...), soit n'émettent aucun rayonnement.

9. Dispositif selon la revendication 8, **caractérisé en ce que** le réglage d'une intensité moyenne perçue par un observateur est effectué par modification de la durée (Δt₁, Δt₂, ...) de l'émission du rayonnement (32).

10. Dispositif selon la revendication 8 ou 9, **caractérisé en ce que** le réglage de la durée (Δt₁, Δt₂, ...) de l'émission du rayonnement (32) s'effectue à chaque instant de commande (t₁, t₂, ...).

11. Dispositif selon l'une des revendications précédentes, **caractérisé en ce que** les trois émetteurs à semiconducteurs (20R, 20G, 20B), qui éclairent chacun une zone d'image (34), peuvent être commandés simultanément.

12. Dispositif selon l'une des revendications précédentes, **caractérisé en ce que** la rampe lumineuse (16) possède au moins une série d'émetteurs à semiconducteurs (20), qui émettent un rayonnement possédant la même longueur d'onde.

13. Dispositif selon la revendication 12, **caractérisé en ce que** pour l'éclairement des zones d'image (34) d'une rangée d'images (38), la rampe lumineuse correspondante (16) comporte trois rangées (218, 220, 222; 518, 520, 522), parallèles entre elles, d'émetteurs à semiconducteurs (20R, 20G, 20B), et les émetteurs à semiconducteurs (20R, 20G, 20B) de chaque rangée émettant sensiblement la même longueur d'onde.

14. Dispositif selon l'une des revendications précédentes, **caractérisé en ce que** parmi les émetteurs à semiconducteurs (20) d'une rampe lumineuse (16), au moins les émetteurs, qui sont associés à un dixième des zones d'image (34) d'une série d'images (38), peuvent être commandés au même instant de commande.

15. Dispositif selon la revendication 14, **caractérisé en ce que** les émetteurs à semiconducteurs (20) d'une rampe lumineuse (16) associés à toutes les zones d'image (34) d'une série d'images (38) peuvent être commandés simultanément.

16. Dispositif selon l'une des revendications précédentes, **caractérisé en ce que** pour la commande simultanée de plusieurs émetteurs à semiconducteurs (20), il est prévu une mémoire intermédiaire (50), dans laquelle les paramètres de commande peuvent être lus en parallèle pour la commande simultanée de la pluralité d'émetteurs à semiconducteurs (20).

17. Dispositif selon la revendication 16, **caractérisé en ce que** la mémoire intermédiaire (50) reçoit entre les instants de commande (t₁, t₂, ...) les paramètres de commande pour les émetteurs à semiconducteurs (20).

18. Dispositif selon la revendication 17, **caractérisé en ce que** les paramètres de commande peuvent être lus en série dans la mémoire intermédiaire (50).

19. Dispositif selon l'une des revendications 16 à 18, **caractérisé en ce que** les paramètres de commande peuvent être produits par un générateur d'images (34).

20. Dispositif selon la revendication 19, **caractérisé en ce que** le générateur d'images (54) produit en série les paramètres de commande.

21. Dispositif selon l'une des revendications précédentes, **caractérisé en ce qu'**à chaque émetteur à semiconducteurs (20) est associée une unité de commande (42, 60), qui mémorise le paramètre de commande depuis un instant de commande (t₁) jusqu'à l'instant de commande suivant (t₂).

22. Dispositif selon l'une des revendications précédentes, **caractérisé en ce que** le système optique de projection (28, 128, 228) forme une image d'une rampe lumineuse (16) successivement sur plusieurs rangées d'images (38a, ..., 38b).

23. Dispositif selon la revendication 22, **caractérisé en ce que** le système optique de projection (28, 128, 228) comprend un élément (130) déviant le rayonnement, qui forme une image de la rampe lumineuse (16) sur des rangées successives d'images (38).

24. Dispositif selon la revendication 23, **caractérisé en ce que** l'élément déviant le rayonnement est un élément réfléchissant mobile (130).

25. Dispositif selon la revendication 24, **caractérisé en ce que** l'élément réfléchissant (130) est déplaçable dans des positions angulaires définies, qui forment l'image de la rampe lumineuse (16) respectivement dans l'une des rangées d'images (38).

26. Dispositif selon l'une des revendications 23 à 25, **caractérisé en ce que** l'élément déviant le rayonnement est formé par un miroir polygonal rotatif (130).

27. Dispositif selon la revendication 26, **caractérisé en ce que** le miroir polygonal (130) tourne avec une vitesse de rotation constante.

28. Dispositif selon la revendication 27, **caractérisé en ce que** le miroir polygonal (130) traverse, avec chaque facette (136) de la surface polygonale, le nombre des rangées d'images (38) sous l'effet d'une rotation sur une plage angulaire déterminée, puis passe à la facette immédiatement suivante (136) de la surface polygonale.

29. Dispositif selon l'une des revendications 23 à 28, **caractérisé en ce que** le système optique de projection (28) focalise le rayonnement des émetteurs à semi-conducteurs (20) de la rampe lumineuse (16) essentiellement sur l'élément (130) déviant le rayonnement.

30. Dispositif selon l'une des revendications 1 à 21, **caractérisé en ce qu'**une rampe lumineuse (16) est associée à chaque rangée d'images (38).

31. Dispositif selon la revendication 30, **caractérisé en ce que** le système optique de projection (428, 628) forme l'image de la multiplicité de rampes lumineuses (16) dans la multiplicité de rangées d'images (38).

32. Dispositif selon l'une des revendications précédentes, **caractérisé en ce que** le système optique de projection (28, 128, 228, 328, 428, 628) produit des zones d'image (34) séparées par de faibles distances.

33. Dispositif selon la revendication 32, **caractérisé en ce que** les zones d'image (34) se jouxtent entre elles pour l'essentiel.

34. Dispositif selon l'une des revendications précédentes, **caractérisé en ce que** le système optique de projection (228, 328) réunit les rayonnements (32R, 32G, 32B) des trois émetteurs à semi-conducteurs (20R, 20G, 20B), qui émettent avec des longueurs d'onde différentes, pour former un faisceau de rayonnement (32V).

35. Dispositif selon l'une des revendications précédentes, **caractérisé en ce que** chaque émetteur à semiconducteurs (820, 920) comprend une source de rayonnement à semiconducteurs (826, 926) et un doubleur de fréquence (832, 932) pour le rayonnement émis par la source de rayonnement à semiconducteurs.

36. Dispositif selon la revendication 35, **caractérisé en ce que** le doubleur de fréquence (832, 932) comprend une structure à guide d'ondes (834, 934), qui guide le rayonnement de chaque source de rayonnement (826, 926) avec une densité de puissance égale à au moins 10⁵ W/cm², d'une manière comprimée, et un milieu (836, 936) qui double la fréquence et est disposé dans la structure à guide d'ondes (834, 934).

37. Dispositif selon la revendication 35 ou 36, **caractérisé en ce que** les doubleurs de fréquence (832) se raccordent directement aux sources de rayonnement (826).

38. Dispositif selon la revendication 35 ou 36, **caractérisé en ce qu'**entre chaque source de rayonnement (926) et chaque doubleur de fréquence (932) est disposé un système optique (930) qui focalise le rayonnement dans la structure à guide d'ondes (934).

39. Dispositif selon l'une des revendications 35 à 38, **caractérisé en ce que** les sources de rayonnement (826, 926) d'une rampe lumineuse (16) sont disposées suivant une rangée et que les doubleurs de fréquence (832, 932) de la rampe lumineuse (16) sont disposés, du côté d'une sortie des sources de rayonnement (826, 926), également suivant une rangée.

40. Dispositif selon l'une des revendications 35 à 39, **caractérisé en ce que** plusieurs des sources de rayonnement (826) sont disposées sur un substrat commun (834).

41. Dispositif selon l'une des revendications 35 à 40, **caractérisé en ce que** plusieurs des doubleurs de fréquence (832, 932) sont disposés sur un substrat commun (838).

42. Dispositif selon l'une des revendications 35 à 41, **caractérisé en ce que** chaque structure à guide d'ondes (834, 934) de chaque doubleur de fréquence (832, 932) est un guide d'ondes "monomode".

43. Dispositif selon l'une des revendications 35 à 42, **caractérisé en ce que** chaque structure à guide d'ondes (834, 934) est formée par un matériau de paroi qui entoure le milieu (836, 936) qui double la fréquence et forme le coeur du guide d'ondes, et possède un indice de réfraction inférieur à celui du coeur du guide d'ondes.

44. Dispositif selon la revendication 43, **caractérisé en ce que** le matériau de paroi est monté sur le même matériau que le milieu (836, 936) qui double la fréquence et possède, sur la base d'un dopage différent, un indice de réfraction inférieur à celui de ce milieu.

45. Dispositif selon la revendication 43 ou 44, **caractérisé en ce que** la structure à guide d'ondes (834, 934) est formée par dopage de zones formant le matériau de paroi, avec un matériau identique à celui du milieu réalisant un doublement de la fréquence.

46. Dispositif selon l'une des revendications 35 à 45, **caractérisé en ce que** la structure à guide d'ondes (834, 934) est constituée par des couches (842, 844, 850) déposées sur un substrat (838, 938) et entourant le matériau de paroi.

47. Dispositif selon l'une des revendications 35 à 46, **caractérisé en ce que** le milieu (836, 936) qui double la fréquence est formé par une couche (850) déposée sur un substrat (838, 938).

48. Dispositif selon la revendication 47, **caractérisé en ce qu'**une orientation définie d'axes optiques du milieu (836, 936) qui double la fréquence est prédéterminée par l'orientation du substrat (838, 938).

49. Dispositif selon l'une des revendications 36 à 38, **caractérisé en ce que** le milieu (836, 936) qui double la fréquence est agencé, et ses axes optiques sont orientés par rapport au canal des guides d'ondes, de telle sorte qu'une adaptation de phase non critique s'effectue entre le rayonnement et le rayonnement dont la fréquence est doublée, dans la direction longitudinale (834, 954) de la structure à guide d'ondes (834, 934).

50. Dispositif selon la revendication 49, **caractérisé en ce que** le milieu (836, 936) qui double la fréquence peut être amené à une température définie.

51. Dispositif selon l'une des revendications 36 à 48, **caractérisé en ce que** le milieu (836') qui double la fréquence est agencé et orienté de telle sorte qu'il se produit quasiment une adaptation de phase dans la direction longitudinale (854) de la structure à guide d'ondes (834).
